(19) Europäisches Patentamt
European Patent Office
Office européen des brevets

(11) EP 2 519 978 B1

## (12) EUROPEAN PATENT SPECIFICATION

(45) Date of publication and mention of the grant of the patent:
**02.09.2015 Bulletin 2015/36**

(51) Int Cl.:
**H01L 31/052** *(2014.01)*     **H01L 31/054** *(2014.01)*
**F24J 2/08** *(2006.01)*     **G02B 3/08** *(2006.01)*
**G02B 3/00** *(2006.01)*

(21) Application number: **09796398.7**

(22) Date of filing: **28.12.2009**

(86) International application number:
**PCT/EP2009/067956**

(87) International publication number:
**WO 2011/079856 (07.07.2011 Gazette 2011/27)**

(54) **PHOTOVOLTAIC CONCENTRATOR WITH OPTICAL STEPPED LENS AND METHOD FOR DESIGNING THE SAME**

PV-KONZENTRATOR MIT OPTISCHER ABGESTUFTER LINSE UND KORRESPONDIERENDES ENTWURFSVERFAHREN

CONCENTRATEUR PHOTOVOLTAÏQUE AVEC LENTILLE OPTIQUE À ÉCHELONS ET PROCÉDÉ POUR SA CONCEPTION

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(43) Date of publication of application:
**07.11.2012 Bulletin 2012/45**

(73) Proprietor: **Pirelli & C. S.p.A.**
**20126 Milano (IT)**

(72) Inventors:
• **GAMBERALE, Luca**
**I-20126 Milano (IT)**

• **GRASSANO, Giuseppe**
**I-20126 Milano (IT)**

(74) Representative: **Acco, Stefania et al**
**Perani & Partners**
**Piazza San Babila, 5**
**20122 Milano (IT)**

(56) References cited:
**EP-A2- 0 254 199     WO-A1-2007/004679**
**JP-A- 59 095 525     US-A- 4 374 609**
**US-A- 4 867 514     US-A1- 2007 147 041**

**Description**

The present invention relates to a solar concentrator comprising an optical lens having a stepped profile for converging radiation. The invention relates also to an optical lens having a stepped profile.

Development of photovoltaic (or solar) cells for electric power generation has been often tailored to provide cost-effective solutions. The cost of solar cells takes up generally a significant portion of the cost of components of solar energy conversion modules. The amount of electrical energy generated by the solar cell is directly related to the amount of solar energy the cell absorbs, which in turn is based on the size or surface area of the cell and the intensity or brightness of the sunlight that strikes the cell, as well as on the conversion efficiency of the solar cell. Thus, increasing the size of a solar cell may end up to be a relatively expensive way to increase the electrical energy produced by the cell.

To reduce costs, it is desirable to increase solar cell efficiencies while minimizing the use of costly materials and fabrication techniques. One promising way to accomplish this is with concentrator systems, where an optical element covering a relatively large sun-lit area is used to greatly concentrate the light onto a relatively small solar cell, thereby greatly reducing the size of the cell required. To this purpose, Fresnel lenses have been used since they are in general thinner, have lower weight and a smaller focal length than the thicker standard lenses.

However, one important limitation of concentrator systems is the need to keep the optical axis of the lenses normal to the sun. The use of such concentrators in practice requires a solar tracking system that keeps the collection optics aligned with the sun as it moves across the sky.

US patent application No. 2005/0092360 discloses an optical concentrator for a solar cell which employs a Fresnel lens element mounted over a solar cell to focus sunlight over the solar cell surface when the concentrator is aligned with the sun and a secondary non-imaging concentrating element mounted intermediate the Fresnel lens and the solar cell to redirect sunlight from the lens including edge rays onto the solar cell surface within the periphery of the active area of the cell when the concentrator is misaligned by a predetermined angle.

US patent application No. 2003/0075212 describes a photovoltaic array module design with a Fresnel lens as first optical concentrator and a compound parabolic concentrator disposed under the Fresnel lens as second optical concentrator.

For solar energy concentration, optical converging devices using total internal reflection (TIR) have been developed, in which converging optical elements employ TIR alone or in conjunction with refraction.

US patent No. 4,337,759 describes a radiant energy redirecting system comprising radiant energy transmitting body means with elements using total internal reflection alone or in conjunction with refraction.

US patent application No. 2008/0092879 discloses a non-imaging concentration or collimation device made of two aspheric lenses. The first lens has an upper aspheric refractive surface and a lower surface that consists of an aspheric surface in its central portion and in a structure with discontinuous slope in its external portion. The second lens surrounds a receiver and consists of a aspheric refractive surface.

US patent No. 4,867,514 discloses an optical system for deviating or changing the direction of, and optionally converging radiation such as solar radiation. The system has a first plane and second plane, where the second plane is laterally movable with respect to the first plane. In an embodiment, the optical elements in the second plane are interrupted wavefront (Fresnel) negative lenses. Spherical aberrations is said to be minimized by using optical elements of non-uniform curvature.

In general, Fresnel lenses have been used since long time for many applications others than solar power generation.

US patent No. 3,883,733 relates to a warning lens for concentrating the intensity of a light source located behind the lens along the centreline of the lens. The lens which provides directional transmission of light passed there through is a thin wall section of a spherical shell having a plurality of coterminous aspheric square convex lenses on the convex side thereof. The concave side has a plurality of concentric triangular lenses having certain predetermined dimensions as set forth in a table.

Use of lenses made of polymeric material simplifies the fabrication of the lenses, since such lenses can be readily manufactured in mass production by moulding, thereby making possible to cut down costs. Furthermore, employing polymeric lenses reduces the weight of the resulting optical element.

Fresnel lenses of general type are usually provided with a first face and second opposite face formed with a series of stepped structures having a saw-tooth shape in a cross-sectional plane. The optical quality of Fresnel lenses has been seen to depend on the shape of said teeth, and in particular of draft facets between refractive portions of two consecutive teeth. In refractive lenses, the draft facets perform no optical functions and should interfere as little as possible with the light path. Ideally, the draft facets should extend substantially parallel to the direction of light beam transmitted through the lens. However, the use of moulding techniques imply design limitations to facilitate lens extraction from the mould and the resulting draft facets may not exhibit a steep front.

EP patent application No. 0117254 discloses a Fresnel lens comprising a plurality of teeth, each of said teeth having a portion effective to refract light rays onto a focus and a slope or flank of connection to the refractive portion of an adjacent tooth, wherein the angle included between said refractive portion and said connection slope or flank is less than 90°, and the teeth are arranged in such a way to follow a spiraling pattern.

When selecting a manufacturing process for the production of a Fresnel lens, and in general for a lens with a stepped profile, several considerations are generally to be made, such as reproduction fidelity (i.e., feature sharpness) and cost of the process per unitary optical element. Typical manufacturing techniques to produce polymeric Fresnel lenses are injection moulding or compression moulding (at atmospheric pressure or in vacuum) or hot embossing. Compression moulding may product lens with sharp features, but it has a long cycle time, which often affects the cost per piece. injection moulding and hot embossing have a relatively short cycle time, but the reproduction fidelity is in general lower than that obtained by compression moulding.

When feature sharpness of a lens obtained by moulding is not acceptable for a particular application, surface finishing by using cutting tools, such by shaping with a diamond tool, can be used. However, precision micro-machining significantly increases manufacturing costs, and therefore may not be desirable for large-scale production of lenses, for instance to be used in solar concentrators.

In *"Plastics Structured Optics for Solar Concentrators in PV System"* by C. Privato et al., published in the proceedings of the International Solar Concentration Conference for the Generation of Electricity and Hydrogen (TCSC-3), 1-5 May 2005, Scottsdale, Arizona, USA, some critical parameters of manufacturing process have been investigated in order to improve the aspect ratio and the optical quality of the moulded stepped lenses.

The present invention comprises an optical stepped lens having a front and a rear surface, wherein the rear surface comprises a plurality of stepped structures, each stepped structure being formed by a slope facet and a draft facet. the slope and draft facets having different inclinations.

Inventors have realised that if radiation impinging onto the lens is hindered from striking the portions of the rear surface corresponding to the non-optical regions of the stepped structures, optical efficiency of the lens will not be affected by the shape of the non-optical regions, e.g. non-verticality of the draft facets and/or roundness of the stepped structures, of and thus by the possible lack of sharpness of such regions.

Inventors have understood that by providing a concentrating lens comprising a rear surface with a stepped profile with a front surface being configured to "pre-focalise" the incident radiation mainly only onto the portions of the rear surface that contiibute to the convergence of the radiation, optical efficiency of the lens significantly increases. They have found that by providing the front surface of a refractive stepped lens with a plurality of converging lenticular elements, each element lying opposite to a respective stepped structure, it is possible to converge the impinging radiation substantially only onto the slope facets of the stepped structures.

Inventors have found that the technical solution according to a main aspect of the invention is suitable also for a stepped optical lens using total internal reflection (TIR), alone or in combination with refraction. Specifically, by employing pre-focalisation on the lens front surface, incident rays can exit from the rear surface in a region within a draft facet not including the peak and valley of the facet, thereby minimising the effects of possible roundness.

The present invention is defined by the terms of the appended claims. According to an aspect and in general terms, the present invention is directed to a solar concentrator comprising at least one solar cell comprising a front surface, and an optical system concentrating solar radiation towards the solar cell. The system comprises an optical stepped lens having a front surface for receiving the solar radiation and an opposite rear surface facing the front surface of the solar cell. The rear surface. has a stepped profile defining a plurality of stepped structures, each stepped structure, in a cross-sectional plane of the lens, has a saw-tooth shape and is formed by a slope facet and a draft facet, slope and draft facets having different inclinations, each stepped structure being charcterised by a pitch (P). The slope facet extends for a first length in the cross-sectional plane and the draft facet extends for a second length in the cross-sectional plane. The front surface of the lens comprises a plurality of contiguous lenticular converging elements, each lenticular element having a fast and a second peripheral edge and a width ($w_L$) extending between the first and second peripheral edges. Each lenticular element lies opposite to a corresponding stepped structure and is configured so that a first ray incident on the first edge of the lenticular element along a first incident direction lying in the cross-sectional plane passes through the lens while being refracted to impinge on the slope facet of the respective stepped structure at a first intercept point, and a second ray parallel to the first ray and incident on the second edge of the lenticular element passes through the lens while being refracted to impinge on the slope facet of the corresponding stepped structure at a second intercept point. The slope portion in the cross-sectional plane comprised between the first and second intercept points within the slope facet extends within the first length and defines a focalisation region of the stepped structure.

In some preferred embodiments, the stepped structures are refractive, wherein the first and second ray are refracted by the slope facet at respective first and second intercept points and exit the lens to converge towards a focal zone.

A plurality of focal zones of incident radiation on the respective plurality of stepped structures form, in some embodiments, a focal region on the front surface of the solar cell.

Preferably, the plurality of stepped structures are arranged transversely adjacent in a plane of incidence perpendicular to the first direction.

Preferably, the peripheral edges of the plurality of lenticular elements lie on a plane of incidence perpendicular to the first direction.

In the preferred embodiments, each lenticular element has a curved surface in the cross-sectional plane. The lenticular elements are outwardly convex.

Preferably, each stepped structure has a pitch of from 0.1mm to 10 mm.

Each lenticular element has a width equal to a pitch of the corresponding stepped structure.

In some embodiments, each stepped structure is characterised by a pitch and each lenticular element has a circular arc profile in the cross-sectional plane with a radius equal to at least three times the pitch of the corresponding stepped structure.

The number of the plurality of lenticular elements corresponds to the number of the plurality of stepped structures.

In some embodiments, the lenticular elements have an aspect ratio of from 0.005 to 0.05.

Preferably, the lens section in the cross-sectional plane corresponding to a stepped structure of the plurality has a maximum thickness and each lenticular element of the lens section has a focal length in the first incident direction largeur than the maximum thickness.

According to some embodiments, in the solar concentrator, a third ray incident along a second incident direction on the first edge of each lenticular element of the optical stepped lens at a first deviation angle with respect to the first incident directions passes through the lens while being refracted to impinge on the slope facet of the respective stepped structure at a third intercept point, and a fourth ray along a third incident direction at a second deviation angle with respect to the first incident direction and incident on the second edge of the lenticular element passes through the lens while being refracted to impinge on the slope facet of the corresponding stepped structure at a fourth intercept point. The portion of the slope facet in the cross-sectional plane extends within the slope facet between the third and fourth intercept points and defines an extended focalisation region of the stepped structure comprising the focalisation region. Preferably, the first and second deviation angle are equal.

In some preferred embodiments, the stepped lens comprised in the solar concentrator is a Fresnel lens with axial symmetry and the stepped structures have an in-plane annular shape. Preferably, the lens has an optical axis parallel to the first incident direction.

In some embodiments, the optical stepped lens of the solar concentrator includes a plurality of stepped structures in which at least a first sub-plurality of the plurality of stepped structures use total internal reflection. Each stepped structure of the first sub-plurality comprises a reflective slope facet and the draft facet receives the first and second ray refracted by the front surface of the lens and reflected by the slope facet from the respective first and second intercept points at respective fifth and sixth intercept points of the draft facet. The draft facet portion extending between the fifth and sixth intercept point extends within the second length.

In some embodiments the optical stepped lens of the solar concentrator is a hybrid lens in which the plurality of stepped structures comprises a first sub-plurality using total internal reflection and a second sub-plurality of stepped structures using refraction, wherein each structure of the second plurality comprise a refractive slope facet and wherein the first and second incident ray striking the refractive slope facet of a stepped structure of the second sub-plurality at respective first and second intercept point of the slope facet are refracted to exit the lens. Preferably, the first sub-plurality of stepped structures is arranged peripherally of the second sub-plurality.

Preferably, the optical system comprised in the solar concentrator further comprises a secondary optical element arranged between the optical stepped lens and the solar cell along the first incident direction to receive the radiation redirected by the lens.

In some embodiments, in the stepped lens comprised in the concentrator, the slope facet and the draft facet of each stepped structure are joined by a peak portion having a curved profile.

In some embodiments, in the stepped lens comprised in the concentrator, the draft facet of a first stepped structure is joined to a slope facet of a next adjacent second stepped structure by a valley portion having a curved profile.

In another aspect, the present invention is directed to an optical stepped lens comprising a front surface for receiving an incident radiation, and an opposite rear surface comprising a stepped profile defining a plurality of stepped structures. Each stepped structure has a saw-tooth shape in a cross-sectional plane of the lens and is formed by a slope facet and a draft facet, the slope and draft facets having different inclinations. The slope facet extends for a first length in the cross-sectional plane and the draft facet extends for a second length in the cross-sectional plane. The front surface of the lens comprises a plurality of lenticular converging elements, each lenticular element having a first and a second peripheral edge. Each lenticular element lies opposite to a corresponding stepped structure and is configured so that a first ray incident on the first edge of the lenticular element along a first incident direction lying in the cross-sectional plane passes through the lens while being refracted to impinge on the slope facet of the respective stepped structure at a first intercept point, and a second ray parallel to the first ray and incident on the second edge of the lenticular element passes through the lens while being refracted to impinge on the slope facet of the corresponding stepped structure at a second intercept point. The slope portion in the cross-sectional plane comprised between the first and second intercept points within the slope facet extends within the first length and defines a focalisation region of the stepped structure.

By having no contribution from the non-sharp portions, relatively low-cost manufacturing techniques may be employed for the production of the stepped lens.

Preferably, in the optical stepped lens, the plurality of stepped structures are arranged transversely adjacent in a plane of incidence perpendicular to the first direction.

Preferably, the peripheral edges of the plurality of lenticular elements lie on a plane of incidence perpendicular to the first direction.

In some embodiments, the stepped lens is a Fresnel lens in which the stepped structures are concentric and annular when viewed in a plane of incidence perpendicular to the first direction.

In other embodiments, the stepped lens is a prismatic lens in which the stepped structures are sequentially arranged substantially parallel one to another when viewed in a plane of incidence perpendicular to the first direction.

In further embodiments, the slope facet and the draft facet of each stepped structure are joined by a peak portion having a curved profile. In an embodiment, the curved profile of the peak portion has a radius of curvature of from 5 to 100 $\mu$m.

In still other embodiments, the draft facet of a first stepped structure is joined to a slope facet of a next adjacent second stepped structure by a valley portion having a curved profile. In an embodiment, the curved profile of the valley portion has a radius of curvature of from 5 to 100 $\mu$m.

Preferably, the maximum depth of a stepped structure, defined as the cross-sectional length difference between the maximum thickness and the minimum thickness of the lens, is not larger than 1.5 mm, more preferably not larger than about I mm.

Within this description and appended claims, with stepped optical lens is meant an optical lens comprising a surface having a stepped profile defining a plurality of stepped structures, in particular having a saw-tooth shape in a cross-sectional plane. Within the present description and appended claims, a saw-tooth shape refers both to a stepped structure with an ideal steep profile and to a structure with rounded peak and/or valley.

The present invention will be now described more fully hereinafter with reference to the accompanying drawings, in which some, but not all embodiments of the invention are shown. Drawings illustrating the embodiments are not-to-scale schematic representations.

FIG. 1 schematically illustrates a cross-section of a conventional Fresnel lens.

FIG. 2 is an enlarged portion E of the cross-sectional view of Fig. 1.

FIG. 3 compares an exemplary stepped profile of an "ideal" Fresnel lens with that of a moulded lens having rounded stepped structures.

FIG. 4 is a diagrammatic cross-sectional view of a refractive Fresnel lens according to an embodiment of the present invention.

FIG. 5 is an enlarged portion G of the cross-sectional view of Fig. 4.

FIG. 6 shows the same lens portion of Fig. 5, further indicating the paths of the incident rays of light across the lends.

FIG. 7 reports an example of a simulated lens profile for a Fresnel refractive lens in accordance with the present invention.

FIG. 8 diagrammatically shows two exemplary lenticular elements of the front surface of a lens, according to an embodiment of the present invention.

FIG. 9a is a top plan view of a solar concentration photovoltaic module, showing an array of Fresnel lenses as primary lenses, according to an embodiment of the present invention.

FIG. 9b is a schematic cross-sectional view taken along the CC line of FIG. 9a and showing a module unit comprising a Fresnel lens according to an embodiment of the invention.

FIG. 10 exemplifies the possible optical path of an off-normal incident ray on a stepped lens, which can for example be a conventional Fresnel lens (only two stepped structures are shown).

FIG. 11 is a schematic cross-sectional view showing a lens section corresponding to a single stepped structure to exemplify the refraction of radiation perpendicular to the plane of incidence and of radiation having a deviation angle $\alpha$ to the perpendicular direction.

FIG. 12 reports results for a simulated lens profile for a Fresnel refractive lens and light rays impinging with a deviation angle of 2°, in an embodiment of the present invention. Only an exemplary portion of the lens is illustrated.

FIG. 13 is a perspective view of a prismatic lens according to an embodiment of the invention.

FIG. 14 shows an exemplary simulated lens profile for a prismatic lens with a single point focus.

FIG. 15 shows a portion of a stepped lens comprising a plurality of transversely spaced TIR stepped structures, according to an embodiment of the present invention.

FIG. 16 is a diagrammatic cross-sectional view of a hybrid stepped lens, according to an embodiment of the present invention.

FIG. 17 illustrates the symbol and angle conventions of the optical path of a ray in and out a lens section used in the equations of Appendix A.

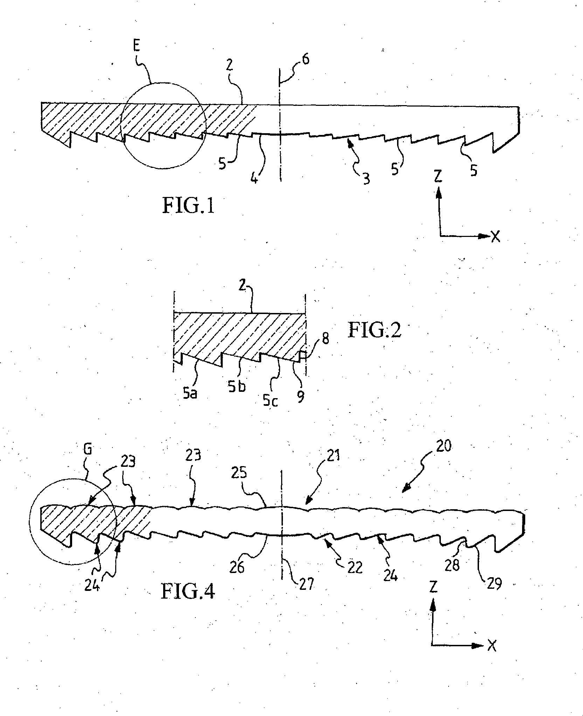

Figure 1 schematically illustrates a cross-section of an exemplary conventional Fresnel lens 1 with axial symmetry with respect to an optical axis 6, which lies in a cross-sectional plane (x,z) along the z-axis. The Fresnel lens has a smooth front surface 2 and a rear surface 3 with a stepped profile defining a plurality of stepped structures 5 disposed concentrically about a central portion 4, the latter having for example a lenticular shape with circular perimeter. The central portion 4 is typically the portion through which the optical axis 6 passes. In the exemplary Fresnel lens shown in the figure, the front surface 2 is flat and the stepped profile of the rear surface 3 is convex with respect to the plane defined by the front surface. The front surface 2 is substantially perpendicular to optical axis 6.

In common designs of Fresnel lenses, near the centre of the lens, the slope facets of the stepped structures 5 are nearly parallel to the front surface, while gradually becoming steeper towards the edges of the lens. The slope angle, $\vartheta_i$, (not indicated in Figs. 1-2) formed by the slope facet of the i-th stepped structure (i=1,2,..,n) with a plane of incidence perpendicular to the optical axis 6, which is in this case a plane parallel to the front surface, can be selected so that the sun rays impinging the lens are redirected by the sloped surface to a predetermined portion of a target surface (e.g., the surface of a solar cell receiving the light) in a common focal plane placed at a focal length, $F_0$. Said portion of the target surface will be preferred to as the focal region. The slope angle of each selected structure can be selected to define a single focal length. Alternatively, the Fresnel lens can be structured to be of a multifocal type, for example when uniformity of illumination within a given zone is of interest or when light is to be redirected towards a further optical element.

In typical applications of Fresnel lenses in photovoltaic concentrators, orientation of the stepped surface is towards the solar cell (grooves "in") due to the potential advantage of avoiding build up dirt and debris within the facets. Although size of the stepped structures may vary in dependence of several factors, such as the desired maximum thickness of the lens, the dimension of the focal region on the cell and/or the concentrator factor, and/or the distance from the centre of the lens, typical pitch of the structures may range from about 0.1 to 10 mm.

Figure 2 shows an enlarged portion E of the Fresnel lens of Fig. 1 in which a few exemplary next adjacent stepped structures 5a, 5b, and 5c defined by the stepped surface are illustrated. For each stepped structure, the cross-sectional shape of the rear surface comprises a slope facet 9, whose inclination, namely the slope angle, with respect to a plane parallel to the front surface, and in general perpendicular to the incident radiation, may vary from one stepped structure to the next adjacent stepped structure, and a steeper draft facet 8 connecting the slope facets of two next adjacent structures. When viewed as a lens section, always in a cross-sectional plane (x,z), the portion of the Fresnel lens corresponding to a single stepped structure has a saw-tooth shape. The slope facets contribute to the refraction of the solar radiation incident onto the front surface, whereas the draft facets have the function of interconnecting two next adjacent slope facets. Ideally, the draft facets are substantially parallel to the direction of incidence of the light rays onto the lens so that they interfere the least possible with the optical path of the rays. As photovoltaic concentrators typically make use of a tracking system to maintain the direction of incidence of the solar radiation to be perpendicular or nearly perpendicular to the front surface of the lens, theoretically, provision of draft facets substantially perpendicular to the front surface, and thus forming sharp apices and valleys with the contiguous slope facets, minimises optical losses.

In reality, manufacturing by moulding generally requires draft facets to be off-normal of a few degrees of tilt, e.g. 1-2° for refractive lenses, to facilitate mould release.

Furthermore, use of relatively low-cost manufacturing process, such as injection moulding, will come at the price of a loss in reproduction fidelity of the features of the rear surface.

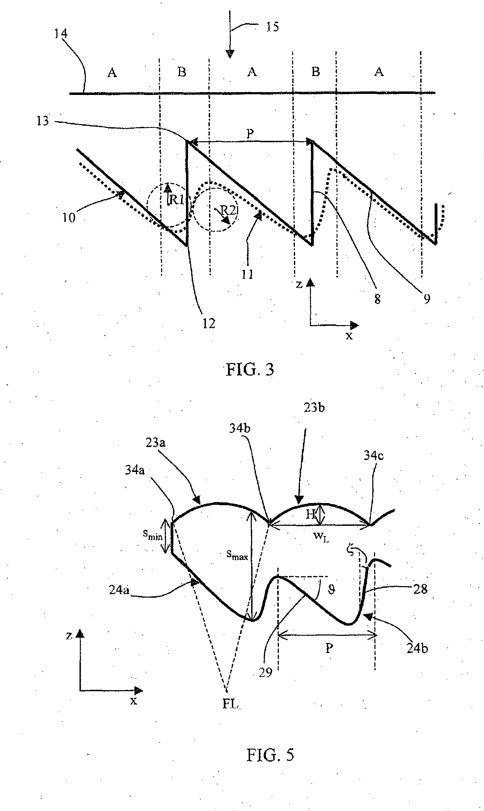

Figure 3 is a schematic cross-sectional view of a portion of a Fresnel lens in which the stepped profile of an "ideal" Fresnel lens (solid line) is compared with an exemplary "renal" stepped profile (dotted line) of a moulded lens, which can be obtained by moulding in which sharp features are not replicated. In the "ideal" stepped profile 10, the slope facet 9 and the draft facet 8 of each stepped structure defines a sharp apex 12 and the draft facet defines a sharp valley 13 with the slope facet of a next adjacent stepped structure. In the "real" stepped profile 11, the sharp apices and valleys have been rounded in peaks and valleys joined by a draft facet that is off-normal with respect to the front surface 14, or off-axis to the direction of incident direction, which is assumed to be along the z-axis, as exemplified by arrow 15. In general, roundness of the peaks and valleys depends on the moulding process, on the material being moulded and on the dimensions of the stepped structures.

The presence of draft facets off-parallel to the incident radiation and of rounded angles significantly reduces the portion of the slope facets of the stepped structures useful for optical refraction of rays that emerge from the rear surface of the lens with a direction convergent to a target area of the focal plane, thereby significantly decreasing the collection efficiency of the lens in photovoltaic applications.

In a cross-sectional plane (x,z), the lens can be divided into "focalisation" regions A comprising the portion of the slope facets "useful" for refraction of the radiation onto a focal zone and interconnecting regions B, which comprise the draft facets and the rounded peaks and valleys. The focalisation regions A are separated by the interconnecting regions B (separation lines are indicated with dot-dashed lines). The ratio between the width of the interconnecting regions B and the width of the focalisation regions A can be taken as a parameter that defines the quality of the lens, the parameter depending on several factors, such as the slope angles of the stepped structures, the draft angles defined between the draft facet and an axis parallel to the incident radiation, and the spacing, P, between two next adjacent valleys 13, referred hereafter to as the pitch of the stepped structure. In general, for a given total surface area of a stepped lens, the higher the number of stepped structures, and thus the smaller the pitch, the more relevant is the lossy contribution of the interconnecting regions.

In a "real" rounded profile of the stepped structures, roundness or curvature can be represented by a first radius of curvature, R1, between the facets within a stepped structure and a second radius of curvature, R2, formed by the rounded valley between two next adjacent stepped structures. In the example shown in Fig. 3, roundness of peaks and valleys of the lens profile is assumed to be described by a circumference, namely the first radius of curvature is the radius of a circumference tangent to the sloped and draft facets of a stepped structure and the second radius of curvature is the radius of a circumference tangent to the draft facet of a stepped structure and to the slope facet of a next adjacent stepped structure (circumferences are indicated with dashed lines). For example, for a Fresnel lens made of polymethyl methacrylate (PMMA) and obtained by injection moulding, the radii of curvatures R1 and R2 of the rounded peak and valley, respectively, can range from about 20 $\mu$m to 150 $\mu$m. It is to be understood that peaks and valleys of stepped structures in moulded polymeric lenses may have a roundness characterised by a plurality of radii of curvature and in general being not defined by a circumference. In Fresnel lenses obtained by other moulding processes, such as compression moulding, roundness of the edges of the stepped profile can be characterised by lower radii of curvatures, e.g. of the order of a few microns, however generally at the expense of a sisnificant increase of per piece cost with respect to the lenses made by injection moulding. Due to light scattering at the rounded edges which causes dispersion of the radiation in directions different from those of the focal region, for which the lens is designed, optical performance of a lens degrade.

Inventors have found that by providing the front surface with a plurality of converging lenticular elements arranged in such a way to converge the incident radiation basically only to the lens focalisation regions A, it is possible to keep the incident radiation off the interconnecting regions B and therefore to at least significantly reduce optical losses.

Figure 4 illustrates a cross-sectional view of a refractive Fresnel lens according to an embodiment of the present invention. A Fresnel lens 20 comprises a front surface 21 and an opposite rear surface 22, as viewed from a cross-sectional plane (x,z) including a lens optical axis 27. The Fresnel lens of the present embodiment is symmetric with respect to the optical axis. The rear surface 22 comprises a central portion 26, which can have a flat surface or be outwardly convex, and a plurality of stepped structures 24 arranged concentrically about the central portion 26, namely around the optical axis 27. Each stepped structure 24 has a saw-tooth shape in the cross-sectional plane (x,z) and is formed by a slope facet 29 and a draft facet 28, the sloped and draft facets having different inclinations.

The front surface 21 is structured to comprise a plurality of optically converging lenticular elements 23, each lenticular element being arranged to correspond, in a cross-sectional plane of the lens, to a respective stepped structure 24 and being configured to substantially converge the impinging light perpendicular to the incident plane into a focalisation region within the slope facet of the respective stepped structure.

The front surface is structured to pre-focalise the light beams impinging perpendicularly onto the lens, by refracting the light that would enter the lens in the interconnecting regions B and directing it in the lens regions A having a sloped profile that contribute to the convergence of the radiation.

A plane of incidence is defined perpendicularly to the incident radiation, i.e. the z-axis in Fig. 4. For "planar" optical lenses, wherein the ends of the lenticular elements substantially lie on a common plane, the plane of incidence crosses substantially the whole lens along the x-axis.

Figure 5 shows an enlarged portion G of the cross-sectional view of Fig. 4, in which two lenticular elements 23a and 23b with respective stepped structures 24a and 24b are shown. In the preferred embodiments, each converging lenticular element of the front surface profile, such as lenticular element 23b, has a surface that is outwardly convex with a first peripheral edge 34b and a second peripheral edge 34c. Each lenticular element acts as a converging optical element, being thickest at its centre while. decreasing in thickness towards its peripheral edges, when viewed in a cross-sectional plane (x,z). A peripheral edge of a lenticular element is defined as the edge of the convex portions of the lenticular element. In many cases of interest, at the peripheral edges. the thickness of the lenticular element is at its minimum.

In some embodiments, perpendicular rays incident on a lenticular element are convergent towards a "virtual" focal point or region, FL (indicated in Fig. 5 only for element 23a), whose distance from the front surface, along the z-axis, depends on the refractive index of the lens and on the aspect ratio of the lenticular element, e.g., on the radius of the lenticular element, in case of a circular lenticular element. Preferably, the focus, FL. of a lenticular element is located at a focal length that is larger than the maximum thickness, $s_{max}$, of the lens section corresponding to the stepped structure opposite to the lenticular element. Figure 5 indicates also the minimum thickness, $s_{min}$, of the lens section corresponding to a stepped structure, the slope angle, $\vartheta$, formed by each point of the slope facet with the plane of incidence and the draft angle, $\zeta$, formed by the draft facet with the direction of incidence.

All lenticular elements can have an equal surface shape, e.g. circular, although this should not be considered limitative of the present invention.

A width, $w_L$, of each lenticular element of the plurality can be defined in the cross-sectional plane (x,z) along the x-axis, the width extending between the two peripheral edges 34b and 34c. In a first approximation, the width $w_L$ corresponds to the pitch, P, namely the distance, always along the x-axis, between two subsequent (next adjacent) valleys of the opposite corresponding stepped structure.

Each lenticular element can be characterised by its aspect ratio, which is defined by the ratio of the maximum height, H, of the element taken in a cross-sectional plane, e.g. (x,z), to the width, $w_L$, wherein the maximum height corresponds to the maximum thickness of the lenticular element. In some preferred embodiments, the plurality of stepped structures have a pitch of from 0.1 mm to 10 mm. The aspect ratio of the lenticular elements may range up to 0.05, preferably from 0.005 to 0.05.

In some preferred embodiments, the stepped lens comprises a plurality of stepped structures having a variable pitch across the plurality of structures. For example, in Fresnel or prismatic lenses, the average inclination of the slope facets, and/or the pitch, can be arranged to vary from one stepped structure to the next.

In a preferred embodiment, the lens has an axial symmetry and the pitch decreases from the lens centre towards the lens periphery.

In some preferred embodiments, the lens comprises a plurality of stepped structures transversely spaced in the plane of incidence from a reference axis perpendicular to the plane of incidence, each pair of consecutive adjacent stepped structures having a first stepped structure arranged peripherally to a second stepped structure with respect to the reference axis, the first stepped structure having a pitch larger than the second stepped structure. In an embodiment, the lens is symmetric and the reference axis is the optical axis passing through the lens centre.

Referring back to Fig. 4, preferably, the lenticular elements are contiguous in a main plane of the front surface 21 perpendicular to the optical axis 27 so that two next adjacent lenticular elements have a peripheral edge in common, at least in the lens sections provided with the stepped structures. In correspondence to the central portion 26 of the rear surface, the front surface 21 can comprise a lenticular element 25 so that a plurality of contiguous lenticular elements are provided across the front surface. Alternatively, a flat region can be provided in correspondence to the central portion 26 of the rear surface (embodiments not shown in the figure). In an embodiment, the central portion 26 of the rear surface comprises a stepped structure. It is to be noted that in many typical configurations for photovoltaic concentrations, the number of stepped structures in a Fresnel lens may be of from 100 to few hundreds so that the central portion makes up only a very small fraction of the lens rear surface area. Therefore, in many cases of interest, the shape of the central portion is not relevant for the optical performance of the lens.

Preferably, for a Fresnel lens, each stepped structure and each corresponding lenticular element are annular in an incident plane, so that the first and second peripheral edges are circumferential, with the second peripheral edge encircling the first peripheral edge, thereby defining an annular region substantially corresponding to the in-plane annular region of the respective stepped structure. In general, the contour defined by the edges of the lenticular elements in the plane of incidence (e.g. annular, rectangular, etc.) preferably depends on the in-plane geometry of the corresponding stepped structure.

Figure schematically shows the paths of the rays of light and indicates the A and B regions for the same lens portion of Fig. 5. In a cross-sectional plane (x,z), the peripheral edges :34a and 34b of each lenticular portion lie within the interconnecting portion B of a corresponding stepped structure in the opposing rear surface.

Considering the lens section extending between the peripheral edges 34b and 34c that define the lenticular element 23b corresponding to a stepped structure 24b in the rear surface, a first ray 30, which is incident perpendicularly to the front surface plane on the first edge 34b of the lenticular element 23b, passes through the lens while being refracted to impinge on the slope facet 29 of the corresponding stepped structure 24b at a first intercept point 32. A second ray 31 parallel to the first ray 30 and incident on the second edge 34c of the lenticular elements passes through the lens while being refracted to impinge on the slope facet 29 of the corresponding stepped structure at a second intercept point 33. The region extending between the first and second intercept points within the slope facet 29 defines the focalisation region A of the stepped structure 24b. A focalisation region of stepped structure 24a can be analogously defined to extend between the intercept point 36 on the slope facet of the structure of a third ray 35 perpendicular to the front surface and incident on a first peripheral edge 34a of lenticular element 23a and the intercept point 37, always on the sloped surface of structure 24a, of first ray 30 incident on edge 34b.

The slope facet of a stepped structure (e.g. 24a or 24b) extends for a first length and the slope facet portion between the first and second intercept points extends for less than the first length.

In general, light rays perpendicular to a plane of incidence and hitting the lenticular elements are refracted and directed towards the focalisation regions where the rear surface well approximates an ideal profile of the stepped structures.

The draft facet of each stepped structure extends between two draft facet ends, which generally correspond to the peaks and valleys. Once the focalisation regions are defined as above, an interconnecting region B is defined between a first focalisation region of a first stepped structure and a second focalisation region of a next adjacent second stepped structure, the interconnecting regions comprising the ends of the draft facet of the first stepped structure.

With the provision of a lenticularly shaped front surface as according to the invention, surface profile and/or lens structure of the interconnecting regions B of the refractive lens do not affect the radiation emerging from the rear surface of the lens. This will allow relaxation of the manufacturing requirements without loss of optical efficiency of the lens.

In an aspect of the present invention, a method for designing a stepped lens is provided, comprising selecting a plurality of input parameters of the lens. The hollowing is a non-exhaustive list of such input parameters: the minimum thickness, $s_{min}$, of the lens; the refractive index of the lens; the position of the optical focus with respect to the lens (a single point if the lens is single-focus or a plurality of points if the lens is multi-focus); the number of stepped structures; the draft angle and the pitch, P, for each stepped structure; the number of lenticular elements (equal to the number of stepped structures) or the radius (or more generally the transverse size) of the lens, the aspect ratio and the width, $w_L$, of each lenticular element corresponding to a respective stepped structure. Preferably, the width, $w_L$, of each lenticular element is taken to be equal to the pitch, P, of the corresponding stepped structure. A main incident direction, which will represent the perpendicular incidence, is defined and from that a plane of incidence perpendicular to the main incident direction.

Following the selection of the input parameters and of the main incident direction, the method of designing the lens comprises calculating the profile of the focalisation region of each stepped structure by using the input parameters for each structure and its corresponding lenticular element. Particularly, the optical path of a first ray perpendicularly incident on a first peripheral edge of the lenticular element corresponding to each stepped structure within the lens and emerging from the lens rear surface, is calculated by applying Snell's law. The position at which the optical path of the first ray intercepts the rear surface, i.e. exit point of the ray, constitutes the first intercept point of the slope facet of the respective stepped structure, which defines in the rear surface a first edge of the focalisation region. Similarly, a second intercept point of the slope facet of the same stepped structure is calculated so that the extension of the focalisation region is determined. Preferably, the method further comprises determining the profile of the focalisation region by calculating the optical path of normal rays incident on the lenticular element at a plurality of incident positions intermediate the two peripheral edges. Shape of the slope facet can be flat or concave. Results can be obtained by numerically solving one- or two-dimensional partial differential equations with the aid of a commercial numerical analysis package, such as MATLAB®.

A brief description of the equations that, according to an embodiment, can be employed to determine the stepped profile of a refractive lens is reported in Appendix A.

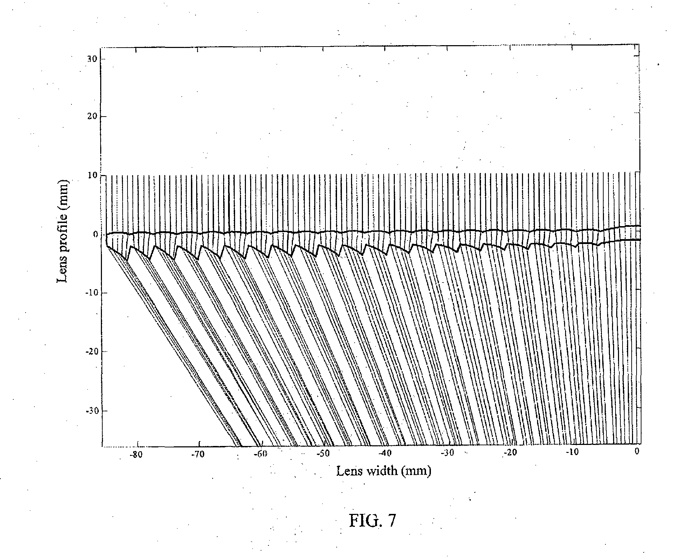

Figure 7 reports an example of a simulated lens profile for a single-focus Fresnel lens resulting from numerical solution of the differential equations based on the application of the Snell's law, according to the above described method. Input parameters were the following: focal length of 0.21 m; lens polymeric material with refractive index of 1.491; twenty-one stepped structures of maximum pitch of 4 mm; minimum thickness, smin, of 3 mm, and spherical lenticular elements of radius, $R_L$, of 8 mm. The lens has an axial symmetry (only half of the lens is shown in the figure). Light rays perpendicular to the plane of incidence are refracted a first time when they enter the lens and a second time when they exit the lens. Said-perpendicular rays emerge from the lens only at the sections that contribute to the focalisation of the impinging beam. The presence of the lenticular elements deviate the rays from the interconnecting regions comprising the draft facets, the peaks and valleys of the rear stepped profile.

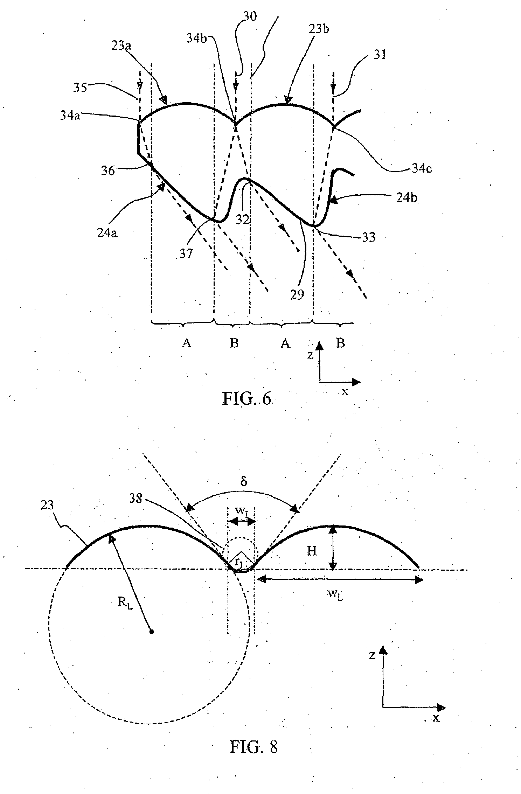

Figure 8 is a partial diagrammatic cross-sectional view illustrating two exemplary lenticular elements of the front surface of a stepped lens according to an embodiment of the present invention. As above described, lenticular elements can be characterised by an aspect ratio, $H/w_L$. In some embodiments, the lenticular elements have, in a cross-sectional view, a circular shape with radius, $R_L$. Some other embodiments may encompass lenticular elements with non circular and generally curved cross-sectional shape.

Depending also on the aspect ratio of lenticular elements, peripheial edges of the lenticular, profile may exhibit sharp features or be rounded (as schematically exemplified in Fig. 8), as a result of the moulding process. In general, roundness of a peripheral edge of a lenticular element can be represented by at least one radius of curvatures, $r_l$. In the example of Fig. 8, roundness is assumed to be represented by a radius of a circumference tangent to two next adjacent lenticular elements (being centred about at the common peripheral edge between the two elements). A transition region of width $w_1$ can be defined between two next adjacent lenticular elements. The angle $\delta$ subtended by the tangents of the two adjacent lenticular profiles in the proximity of the transition region can be selected to be relatively large, for example, $\delta = 160°$, thereby allowing for an easy moulding of that region. The width of such regions is usually much smaller than the width of the corresponding B-regions (typically less than 10% of B-regions width) and their negative influence on the overall optical efficiency of the lens is therefore negligible.

In application for solar concentrators, for concentrating solar radiations with concentration factors of from 500x to 1000x onto photovoltaic cells having entrance surface area of about from 1 mm$^2$ to 100 mm$^2$, Fresnel lenses can be for example designed with stepped structures having a pitch, P, of from about 1-1.5 mm. Inventors have noted that the, in many practical cases of interest, interconnecting regions of the stepped structures may occupy 5-10% of the lens, i.e. ~50-100 $\mu$m. For example, for lenticular elements with aspect ratio of 0.025, lenses with roundness of the transition regions between two next adjacent lenticular elements can have a radius of curvature, $r_l$, of 20 $\mu$m, which corresponds to a width, $w_l$, of the transition region of the order of a few microns, approximately at least a factor of ten lower than the width of the lens interconnecting regions B. Therefore, in many cases of interest, possible imperfections of the contour of the front surface do not significantly influence the optical performance of the lens.

In general, depending *inter alia* on the pitch of the stepped profile and on the lens minimum thickness, lenticular elements can be provided with a relatively low aspect ratio. Generally, the lower the minimum thickness of the lens, $s_{min}$, the larger the convexity of the lenticular elements, thus the larger their aspect ratio. Provision of lenticular elements with relatively low aspect ratio allows the moulding of the front surface of the lens with a relatively high reproducibility factor.

In some embodiments, the aspect ratio of the lenticular elements is of from 0.005 to 0.05.

For example, a circular Fresnel or a prismatic lens provided with lenticular elements with circular cross-sectional shape and being made of PMMA is designed having the following parameters:

lens diameter: 100 mm
number of stepped structures: 20
pitch: 2.5 mm
refraction index of PMMA: 1.4935
radius of lenticular elements: 6 mm.
minimum thickness, $s_{min}$: 3 mm

In the given example, for radii of curvature R1 and R2 of the facets of the stepped structures of about 50 $\mu$m, the width of the interconnection regions B was calculated to be of about 0.15 mm between the A regions of each stepped structure. To a first approximation, the loss in optical efficiency of the lens, where the front surface is substantially flat, would have been of 0.15/2.5=6%. For a plurality of lenticular elements having a radius of curvature, $r_l$, at the edge between two next adjacent lenticular elements of 30 $\mu$m, the width, $w_l$, of the region where inaccuracies of the front surface due to moulding are expected to occur is of about 6 $\mu$m. The loss in optical efficiency due to the roundness of the edges of the lenticular elements for such a lens is of about 0.006/2.5=0.24%.

Figures 4 to 7 refer to a "planar" stepped lens, in which the lenticular elements of the front surface lie on a common front main plane which can be taken to be the incident plane and the stepped structures of the rear surface lie on a common main rear plane, substantially parallel to the first main plane. However, the present invention encompasses a stepped lens wherein the lenticular elements and/or the stepped structures lie on a non-planar and generally curved surface. In particular, the peripheral edges of the lenticular elements can lie on a curved surface. For example, the stepped lens can have a dome-shaped front surface so that the lenticular elements are arranged on a outwardly convex surface and the stepped structures are arranged on a concave rear surface.

In some embodiments, the average thickness of the lens is not larger than 4 mm, preferably of from 3 mm to 4 mm. Preferably, the minimum thickness, $s_{min}$, of the lens is not smaller than 3 mm and preferably not larger than 5 mm.

In some preferred embodiments, the depth of the draft facet, $(s_{max}-s_{min})$, for each stepped structure is not larger than about 1 mm.

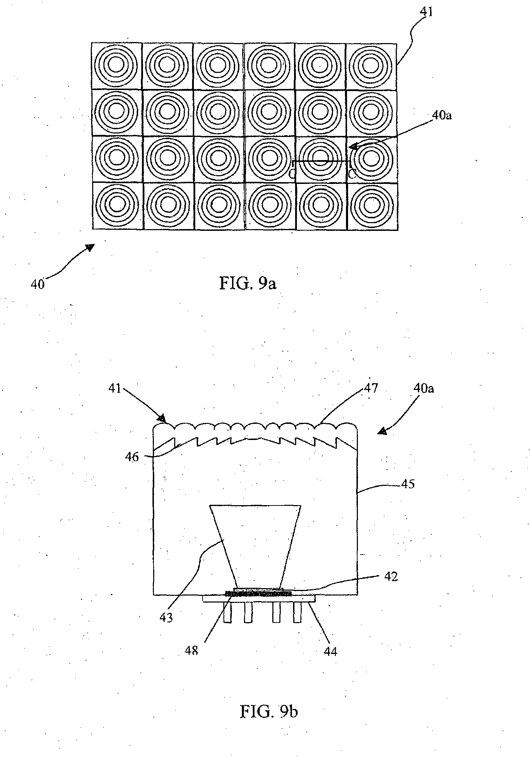

Figure 9a illustrates a schematic top plan view of a solar concentrator 40 comprising an array of solar cells forming a photovoltaic module where cells are arranged in rows and columns and comprising an array of Fresnel lenses 41, each lens being arranged in correspondence to a respective solar cell (not visible in Fig. 9a). Figure 9b is a diagrammatic perspective view of a module unit 40a comprising an individual solar cell taken along the CC line of Fig. 9a. The solar concentrator 40 can be realised by assembling a plurality of module units. Fresnel lenses have a square shape in a plan view and comprise a front surface with respect to the incident rays and a rear surface, the rear surface comprising a plurality of stepped structures 46 disposed concentrically about an optical axis with an annular geometry in a plane perpendicular to the optical axis. Fresnel lens 41 acts as a primary optical element and is oriented with respect to the solar radiation with the rear surface towards a solar cell 42. The front surface comprises a plurality of converging lenticular elements 47, each element corresponding to a stepped structure 46 so as to pre-focalise the incident beam on the focalisation regions of the lens rear surface. Each module unit can comprise a secondary optical element (SOE) 43 which serves as a light "funnel" to direct the light focused by the Fresnel lens onto the cell. For example, the secondary optical element can comprise a reflective inverted truncated pyramid with the smaller aperture coincident to the perimeter of the PV cell. In an embodiment, solar cell 42 is mounted on a supporting receiver 48 that manages both heat dissipation and electrical isolation from the housing 45 of the solar cell. A heat spreader 44 is attached to receiver 48 to dissipate heat that is associated with the operation of the cell and the concentration of sun rays.

In an embodiment, the front surface of the stepped lens and preferably also the rear surface of the lens, are coated with an anti-reflection coating.

In an embodiment, the profile of the lenticular elements of the stepped lens is adapted so as to have stepped structures in which the slope facets are flat segments, when viewed in a cross-sectional plane, and so as to have rays incident on the lens converge to a common single focal region.

Stepped lenses made by moulding are preferably made of polymeric materials, such as polymethyl methacrylate (PMMA), polystyrene, or polycarbonate.

In the foregoing embodiments, particular reference has been made to a perpendicular incidence to a plane of incidence across the front surface. In case of applications of solar concentrators making use of solar trackers, which follow the sun direction during day, the condition of perpendicular incidence represents a good approximation of direction of the incident radiation during operation of the solar concentrator. However, mechanics tracking accuracy, precision, of the assembly and thermal expansion of materials forming the optical elements set in practice a tolerance of off-axis incidence of the solar concentrator.

Furthermore, small misalignments between parts of the tracking equipment and/or between the components of the optical system (e.g. optical misalignments between the primary lens and the SOE) and the solar cell can contribute to move off normal incidence.

Inventors have observed that, even for a stepped optical lens that exhibit an "ideal", sharp stepped profile, for some applications, it can be advantageous to provided an optical system for photovoltaic concentration that is capable of efficiently operating within a relative wide off-normal angle, i.e. up to about 2° when the concentration factor is around 500x or higher.

As described above, by provision of a stepped lens according to the general principles of the invention and under the assumption of perpendicular, incidence of radiation, the lens can be designed by providing a plurality of lenticular elements, each , corresponding to a respective stepped structure of the rear surface, configured so as to direct the incident rays onto a desired localisation region A comprised within the slopes potion of the stepped structures.

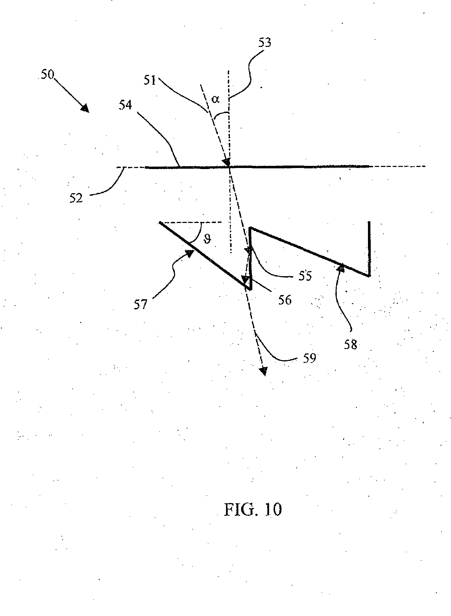

Figure 10 exemplifies the possible optical path of an off-normal incident ray on a stepped lens, which can for example be a conventional Fresnel lens (only two stepped structures are shown). For sake of simplicity, the front surface of the lens is assumed to lie on a main incident plane. Fresnel lens 50 has a front surface 54 lying on incident plane 52 and a rear surface comprising a plurality of stepped structures. In the present embodiments, stepped structures 57 and 58 have an "ideal" profile with draft facets normal to the incident plane. Light ray 51 impinges with a deviation angle $\alpha$ with respect to the axis 53 perpendicular to the incident plane 52 on the front surface 54 and representing the normal direction. Ray 51 is refracted at the interface with the lens front surface and, depending on the value of angle $\alpha$, instead of reaching the slope facet of the stepped structure 57 and then being correctly refracted towards the focal region, may hit the draft facet 56 at point 55 and get totally reflected towards the slope facet 57. It finally exits through the slope facet of the stepped structure 57 with a different angle. Therefore, the off-normal ray can be refracted by the rear surface to exit the lens with a direction off-focus (exemplified by refracted ray 59).

Inventors have understood that, by providing a lenticular profile on the lens front surface, once the focalisation regions of the stepped structures are determined, it is possible to design the lens in such a way that also rays impinging the front surface of the lens with a given deviation angle $\alpha$ are still focused in the desired focal region. Pmferably, the deviation angle is largeur than zero and not larger than 2°.

In an embodiment, an extended focalisation region. A', is defined for each stepped structure by lengthening the slope facet outside the region A, beyond the first and second intercept points by a respective first and second portion. In an embodiment, the extended focalisation region is determined by analytic prolongation of the segment A (focalisation region) on both opposite sides, i.e. past the first and second intercept points.

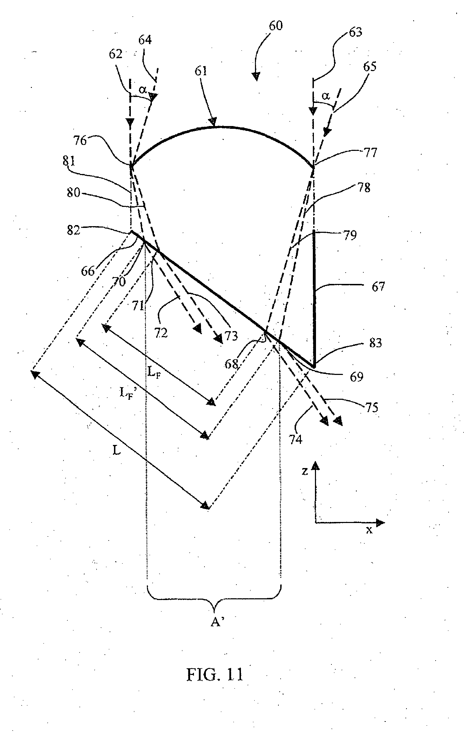

Figure 11 is a schematic cross-sectional view showing a lens section corresponding to a single stepped structure to exemplify the refraction of radiation perpendicular to the plane of incidence and of radiation having a deviation angle $\alpha$ to the perpendicular direction. Lens section 60 shows a lenticular element 61 comprised in the front surface of the lens and being opposite to a stepped structure on the rear surface of the lens having a slope facet 66 and a draft facet 67. A first ray 62 having a first incident direction striking on a first peripheral edge 76 of the lenticular element is refracted into a ray 80 that passes the lens and impinges the slope facet 66 of the stepped structure on a first intercept point 71. In some preferred embodiments, the lenticular elements lie on a common plane of incidence and the first ray 62 is perpendicular to the common plane. A second ray 63 parallel to the first ray 62 and striking onto a second peripheral edge 77 of the lenticular element 61 is refracted into a ray 79 that passes the lens and impinges on the slope facet on a second intercept point 68. The refracted ray 79 is again refracted at the first intercept point to exit the lens along a direction 74 towards a focal zone. The slope facet portion taken in a cross-sectional plane of the lens comprising the first and second incident directions and extending between the first and second intercept, points 71 and 68 defines the focalisation length, $L_1$, of the slope facet. Being L the length of the sloped facet in the cross-sectional plane and extending between ends 82 and 83 of the slope facet, in the preferred embodiments, the slope facet portion of the focalisation region A has a length $L_F < L$. The focalisation region A extends in the rear surface of the stepped structure for an area of length $L_F$.

An off-axis incident radiation is now considered. Specifically, a third ray 64 incident on the first peripheral edge 76 at an angle $\alpha$ to the first incident direction is refracted and strikes the slope facet at a third intercept point 70 being in closer proximity to the end 82 of the facet than the first intercept point 71. A fourth ray 65 incident on the second peripheral edge 77 at an angle $\alpha$ to the first direction is refracted and strikes the slope facet at a fourth intercept point 69 being in closer proximity to the end 83 of the facet than the second intercept point 68. The slope facet portion taken in the cross-sectional plane of the lens and extending between the third and fourth intercept points 71 and 68 defines an extended focalisation region A' of the slope facet, the extended focalisation region comprising the focalisation region A. In the cross-sectional plane, the length $L_1'$ of the extended focalisation region is not smaller than $L_1$ and for angles substantially different from zero, e.g. larger than 1-1.5°, is larger than $L_F$. Preferably, $L_1' < L$. In order to define the profile of the extended focalisation region A', a mathematical extension can be performed to the calculated profile of the focalisation region A, e.g. by fitting the calculated profile of the focalization region. A with a polynomial function and prolonging the latter beyond the ends of the focalization region A.

In the embodiment described with reference to Fig. 11, it is assumed that the incident rays are refracted as they enter and they leave the lens, i.e. the stepped structure is purely refractive.

In the figure, the slope facets (and the draft facet) are shown in the cross-sectional plane as segments. However, they can be a curved line, namely in some embodiments the slope facet is curved surface. The length, L, of the slope facet of a stepped structure is taken to be the distance between the peak and the valley of the structure.

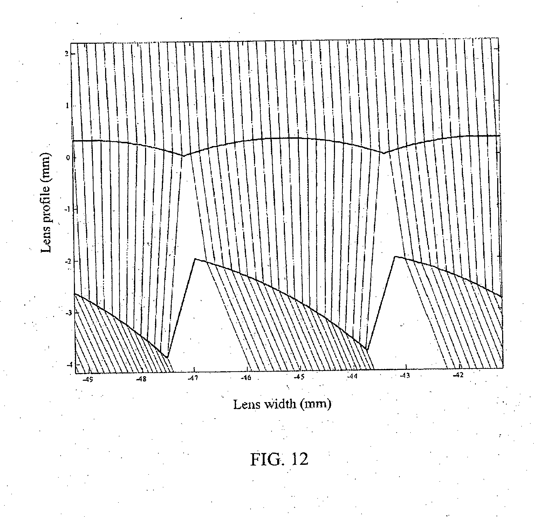

Figure 12 reports results for a simulated lens profile obtained by numerical solution of the differential equations based on the application of the Snell's law for light rays impinging with a deviation angle of 2° (only an exemplary portion of the lens is illustrated). Lens input parameters are the same as those described with reference to Fig. 7. It is noted that also in case of the presence of a deviation angle as large as 2°, light is prevented from exiting the lens in the sections corresponding to the draft facets and in particular to the sections including the ends of the draft facets. Rays refracted at the slope facets are directed to a respective focal zone. The plurality of focal zones of incident radiation on the respective plurality of stepped structures form a focal region.

Although reference has been made to a lens focal zone, it is to be understood that the lens can be designed to define a focal point/area in combination with an additional optical elements, such as a secondary optical element (SOE). In that case, the focal region is that of the optical system comprising a primary stepped lens and a SOE.

It is also noted that the invention encompasses a stepped lens in which each stepped structure has a respective focal point or a respective focal,zone.

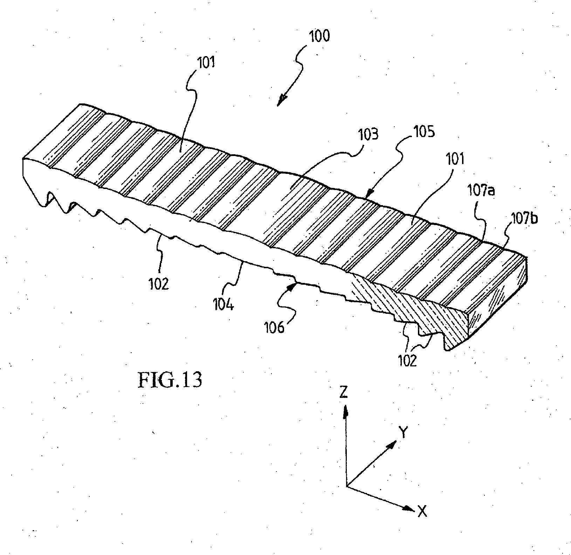

Figure 13 illustrates an optical stepped lens according to a further embodiment of the invention. Specifically, Fig. 13 is a perspective view of a prismatic lens 100 comprising a front surface 105 and an opposing rear surface 106. The rear surface 106 comprises a central portion 104 and a plurality of contiguous stepped structures 102 arranged outwardly away from the central portion 104. The front surface 105 comprise a plurality of contiguous lenticular elements 101, each lenticular element having a first and a second peripheral edge 107a and 107b and being arranged in correspondence to a respective stepped structures 102 in a cross sectional plane (x,z). The plane of incidence is the (x,y) plane. Being, in this embodiment, the lenticular elements contiguous, a peripheral edge of a lenticular element is in common with a peripheral edge of a next adjacent lenticular element. The width of each lenticular element defined by its peripheral edges is substantially equal to the pitch of the respective stepped structure. The shape of the lenticular elements when viewed in a top plane view is square or rectangular and substantially corresponds to the shape of the stepped structures in a plan view of the rear surface.

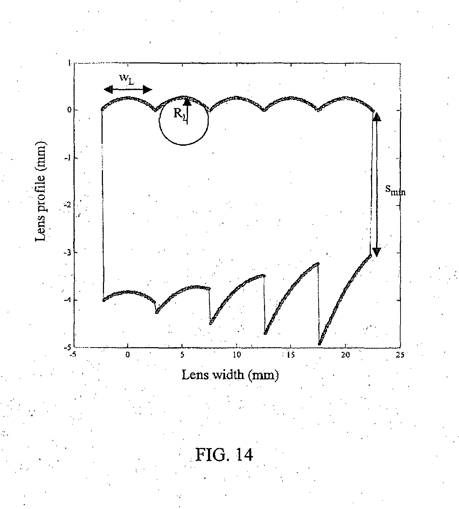

Figure 14 shows an example of a calculated lens profile for a prismatic lens. In the abscissa, the lens width is in mm and in ordinate the lens profile is in mm: however, the scales are not the same in the two axes, so that the slopes are only schematic and not realistic. The lens has a total width in a plane perpendicular to the optical axis of 22.5 mm, five stepped structures and linear focus positioned at (0, -100 mm) in the cross-sectional plane. The lenticular elements have a circular cross-section with radius, $R_L$, of 12 mm and the stepped structures have a width of 5 mm. For each point of the front surface of a lenticular element, a point of the slope facet of the corresponding stepped structure is calculated by following the procedure described above. The focalisation region of each stepped structure is extended by 0.2 mm on each side past the intercept points by fitting the focalisation region with a cubic polynomial. In this example, the profile of the slope facets is curved inward the lens. i.e. concave.

In some applications, purely refractive optical lenses may exhibit, physically inherent limitations in concentrating incident radiation.

Generally, an optical lens is characterised by the f-number, f, which is the focal length, F, divided by the diameter of lens, by considering, only for sake of simplicity, a circular lens. For reasons of compactness and modularity of photovoltaic concentrators, it is sometimes preferred that the focal length of the concentrating optical lens is not too large. e.g. larger than 150-200 mm, the value depending on many factors, such as construction details of the photovoltaic concentrator. In addition, the Applicant has observed that, by a given deviation angle from the perpendicular incidence, the shift in the focal plane is larger for a larger focal length.

On the other hand, the shorter the f-number, the more the radiation needs to deviate across the lens from the incident direction to concentrate towards a focal point or area, i.e., the focal zone. Furthermore, for radiation impinging on the rear surface at angles smaller than the critical angle, the portion of reflected light, which will be lost from concentration, increases when the angle approaches the critical angle, especially in case of a refractive stepped lens with relatively short f-number, f, thereby decreasing the efficiency of the lens. In practice, an f-number lower than 1-1.2 may decrease the efficiency of the concentrating optical system to an unacceptable level

When the incident radiation impinges a facet of the stepped structures of the rear surface with an angle equal or larger than the critical angle, total internal reflection (TIR) takes place and, at that facet, all radiation is reflected, with virtually no loss. The Applicant has realised that in some applications, in particular in some photovoltaic applications, use of an optical stepped lens using total internal reflection, alone or in combination with refraction, can be advantageous. As it is generally possible to design a TIR stepped structures with a relatively exit angles, namely providing a relatively large deviation of the incident radiation by the lens, it is possible to realise a high-efficiency lens, e.g. close to 90% for a lens made of PMMA, having a relatively short focal length, e.g., not larger than 150 mm, and preferably not larger than 100 mm.

The Applicant has observed that, for a given pitch, a TIR stepped structures can be up to three times deeper than a refractive stepped structure. This can magnify the problem of reproduction fidelity of the structures in the moulded lenses with respect to a purely refractive stepped lens. For example, by employing common moulding techniques such as injection moulding in manufacturing polymeric lenses, a finite draft angle, e.g. 4°, is in many cases necessary to allow extraction of the lens from the mould, thereby enhancing the roundness of the structures.

In a TIR stepped lens for concentration of radiation, the draft facet has an optical function and consequently in conventional lenses using TIR, needs to be accurately defined. In particular, the light impinges onto the front surface, i.e. the front interface which conventionally is a flat segment, strikes onto the reflecting slope facet of a stepped structure, which redirects it onto the draft facet of the same structure, in turn refracting the exiting ray. The draft surface thus constitutes a refractive interface for the incident radiation.

Inventors have understood that provision of a front surface having a lenticular profile, in which a convergent lenticular element is arranged in correspondence to each TIR stepped structure, allows to direct the incident radiation only onto a "central" portion of the draft facets of the stepped structures, i.e., to avoid that the incident radiation strikes the rear surface in correspondence to the peaks and valleys of the structures. This permits a higher degree of flexibility in the design and/or manufacturing of the lens, as roundness of peaks and valleys of the stepped structures can be tolerated, at least for normal incident radiation. For example, in a TIR stepped lens with a front surface comprising a plurality of lenticular elements having a radius of curvature of from 5 to 100 $\mu$m, draft angles between about 2° and 6° formed by the draft facet with the normal to the lens incident plane are possible without significant loss in optical efficiency with respect to a zero draft angle.

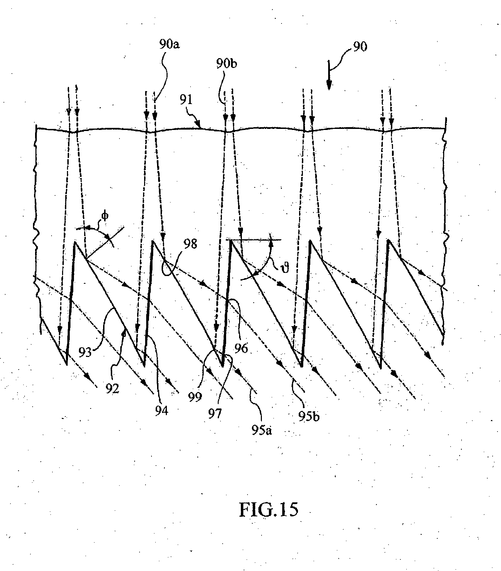

Figure 15 illustrates a portion of a stepped lens comprising a plurality of transversely spaced TIR stepped structures, according to an embodiment of the present invention. Each stepped structure 92 comprises a slope facet 93 and a draft facet 94. On the front surface receiving the incident radiation, represented by arrow 90, a plurality of lenticular elements 91 are provided, each lenticular element corresponding to a respective stepped structure 92 on the opposite rear surface. The slope facet 93 forms a slope angle $\vartheta$ with the incident plane crossing the front surface. Total internal reflection occurs when the angle of incidence of the ray with the normal to the surface is greater than the so-called critical angle of the interface, which is given by arcsin(1/n), with n being the refractive index of the lens. A light ray enters through a lenticular element of the front surface and strikes the slope facet 93 with angle $\phi$>arcsin(1/n), which redirects it by reflection toward the exit interface (draft facet 94), the two facets of the stepped structures and the lens front surface comprising the active interfaces for that ray.

The lenticular profile on the front surface is configured to pre-focalise the incident radiation onto the focalisatioil region of the slope facet and redirect the reflected radiation onto the region of the draft facet not including the peak and valley. Light rays 90a and 90b enter the respective peripheral edges of a lenticular element 91 and strike the slope facet 93 on respective first and second intercept points 98 and 99 to be reflected towards the draft facet 94. Rays reflected at intercept points 98 and 99 impinge on the draft facet on respective intercept points 96 and 97 to be refracted and exit the lens as rays 95a and 95b directed towards a focal zone.

In an embodiment, the stepped lens is a hybrid lens comprising a plurality of stepped structures including a first sub-plurality of refractive stepped structures transversely spaced with respect to the incident radiation and a second sub-plurality of transversely spaced TIR stepped structures. Preferably, the second plurality of stepped structures is arranged externally the first plurality of stepped structures. More preferably, the stepped structures of the first and second plurality are annular in shape in a plan view and the second plurality of stepped structures are arranged concentrically the first plurality.

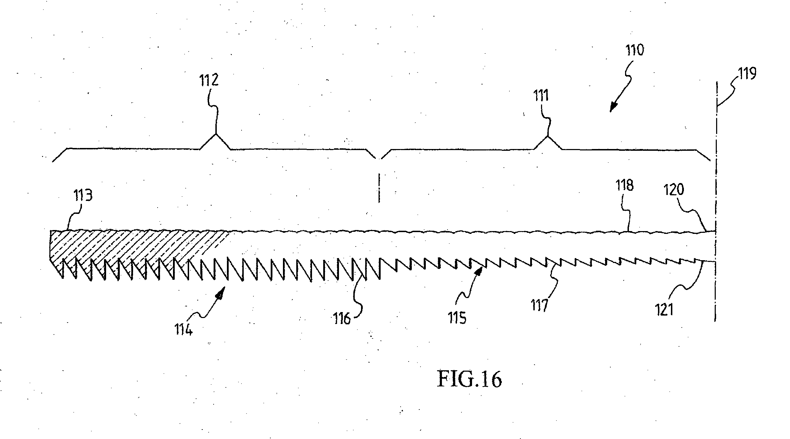

Figure 16 illustrates a partial cross-sectional view hybrid stepped lens, according to an embodiment of the present invention. Lens 110 is a Fresnel lens comprising a rear surface having a stepped profile and a front surface comprising a lenticular profile. Only half of the lens is shown in the figure. The rear surface comprises a plurality of stepped structures including a first sub-plurality 115 of stepped structures 117 being configured to refract the incident radiation, i.e. the angle of the ray incident on the slope facet of a structure of the first sub-plurality with the normal to the same facet at the incident point is smaller than the critical angle, and a second sub-plurality 114 of stepped structures 116 being configured to use TIR, i.e. the angle of the ray incident on the slope facet of a structure with the normal to the same facet is equal to or larger than the critical angle.

Preferably, the lens 110 has an axial symmetry about an optical axis 119 so that the not shown second half lens is equal and mirror-like with respect to the first half. However, the embodiment is not limited to an axially symmetric lens. For example, the second portion of the lens can be different from the first portion, e.g., it comprises more or fewer stepped structures on the rear surface and, correspondingly, more or fewer lenticular elements.

Preferably, the hybrid lens is of Fresnel type, namely both refractive and TIR stepped structures are annular in shape when viewed on a plane of incidence, in this case perpendicular to the optical axis 119. The first sub-plurality 115 of refractive stepped structures 117 is disposed concentricallyin a plane perpendicular to the optical axis around a central portion 121 of the rear surface, The central portion 121 can have a lenticular shape. The second sub-plurality 114 is arranged peripherally the first sub-plurality 115 of stepped structures. In particular, the TIR stepped structures 116 are arranged concentrically about the optical axis and peripherally with respect to the refractive stepped structures 117.

The front surface comprises a plurality of lenticular elements, each lenticular element lying opposite to a corresponding stepped structure. In particular, a first sub-plurality 111 of lenticular elements 118 is arranged opposite to the first sub-plurality 115 of stepped structures and a second sub-plurality 112 of lenticular elements 113 is arranged opposite to the second sub-plurality 114 of stepped structures. The number of lenticular elements of the first sub-plurality 111 corresponds to the number of the stepped structures of the first sub-plurality 115. The number of lenticular elements of the second sub-plurality 112 corresponds to the number of the stepped structures of the second sub-plurality 114. A central portion 120 of the front surface corresponding to the central portion 121 of the rear surface can comprise a lenticular element or being flat.

Preferably, the plurality of lenticular elements comprises a first sub-plurality and a second sub-plurality. The lenticular elements of the first sub-plurality correspond to refractive stepped structures. The lenticular elements of the second sub-plurality correspond to TIR stepped structures.

Preferred embodiments illustrated in the figures refer to an optical lens having axial symmetry. It is to be understood that the present invention encompasses a stepped lens in which the plurality of stepped structures are arranged asymmetrically on the rear surface of the lens and more generally the lens has no axial symmetry.

Although the preferred embodiments refer to a stepped optical lens for photovoltaic and more generally for solar concentrators, the optical lens according to the present invention.encompasses other applications that require convergence of light from a relatively large regional area to a significantly smaller aperture. In particular, the lack of sharpness of the stepped structures due to a low reproduction fidelity can degrade the image quality in imaging applications.

Furthermore, the Applicant believes that provision of a stepped lens that allows convergence of incident radiation that is off-normal of a few degrees can be advantageous in imaging applications, for example in video projectors and photographic applications.

Appendix A

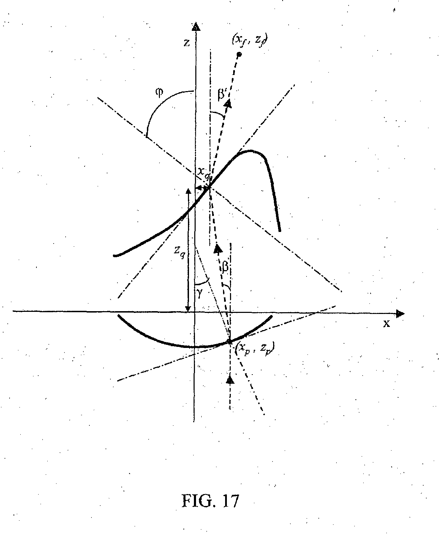

Reference is made to Fig. 17 for symbol and angle conventions in the coordinate system used in this Appendix and in the following equations.

A single-focus optical stepped lens with refraction index n is considered. A 2D Cartesian coordinate system (x, z) is set in such a way that the optical axis corresponds to the z-axis and the origin of the system is positioned at the centre of one of the lenticular profiles of the lens (at the bottom of the figure) with respect to the plane of incidence passing through the x-axis and perpendicular z-axis. It is noted that within the description of this Appendix and with reference to Fig. 17, the lens is oriented with the front surface placed downwardly the rear surface, from which the light exits, in the semi-space of negative z-values, where the z-axis, differently from the convention shown in the remaining figures, points towards the rear surface of the lens.

The incident radiation impinges a circular lenticular profile at a point $(x_p, z_p)$ in which the perpendicular to the profile forms an angle $\gamma$ witch the z-axis.

The profile of the rear surface of the lens corresponding to the lenticular profile is calculated, with the condition that the incident radiation is converges to a single focal point positioned at $(x_f, z_f)$ and the slope facet of the stepped structures refracts the impinging radiation that then exits along a converging direction. Galled $(x_q, z_q)$ the coordinates of the generic point of the slope facet of a stepped structure from which a generic ray exits, the hollowing equations hold. By convention, sign of angles is taken with reference to the coordinate system.

With reference to Fig. 17 and to the chosen coordinates system, the exit angle, β', formed with the z-axis is:

$$\tan \beta' = \frac{x_q - z_f}{z_q - z_f} \qquad (1)$$

By applying the Snell's law, the exit angle β' is related to the angle β of the ray refracted by the lenticular element and to the angle φ of ray refracted by the slope facet by:

$$n \cdot \sin(\varphi + \beta) = \sin(\varphi + \beta'), \qquad\qquad (2)$$

where the angle $\varphi$ is defined by

$$\tan \varphi = \frac{dz_q}{dx_q}. \qquad\qquad (3)$$

By further applying the Snell's law at the generic point $(x_p, z_p)$ of the lenticular profile, the incident angle $\gamma$ can be related to the angle $\beta$ by:

$$\sin \gamma = n \sin(\gamma - \beta), \qquad\qquad (4)$$

and to the radius of curvature of the lenticular profile, $\rho$, by:

$$\sin \gamma = -\frac{x_p}{\rho}. \qquad\qquad (5)$$

The refracted ray propagating within the lens is related to the coordinates of the slope facet of the stepped structure $(x_q, z_q)$ and to the coordinates $(x_p, z_p)$ of the entrance point on the surface of the lenticular element by:

$$\tan \beta' = \frac{x_q - x_p}{z_q - z_p} \qquad\qquad (6)$$

The differential equation that determines the profile of the rear surface is provided by the following relation:

$$\tan \varphi = \frac{dz_q}{dx_q} = \frac{dz_q}{dx_p} \frac{dx_p}{dx_q} \qquad\qquad (7)$$

To solve the equation, the coordinate $x_p$, is taken as independent variable:

$$\frac{dz_q}{dx_p} = \tan \varphi \left( \frac{dx_p}{dx_q} \right)^{-1} = \tan \varphi \left( \frac{dx_q}{dx_p} \right) \qquad\qquad (8)$$

As $x_q = \tan \beta(z_q, z_p) + x_p$,

$$\frac{dx_q}{dx_p} = \left[ \frac{d}{dx_p} \tan \beta \right](z_q - z_p) + \tan \beta \left( \frac{dz_q}{dx_p} - \frac{dz_p}{dx_p} \right) + 1 \qquad\qquad (9)$$

By combining Eq. (9) with Eq. (8) the following relation is obtained:

$$\frac{dz_q}{dx_p} = \frac{\tan \varphi}{1 - \tan \varphi \tan \beta} \left\{ \left[ \frac{d}{dx_p} \tan \beta \right](z_q - z_p) - \frac{dz_p}{dx_p} \tan \beta + 1 \right\} \qquad\qquad (10)$$

By expressing the quantities $\frac{d}{dx_p} \tan \beta$, $\tan \varphi$ e $\frac{dz_p}{dx_p}$ in terms of $x_p$, Eq. (10) can be written as:

$$\frac{dz_p}{dx_p} = -\tan \gamma \qquad (11)$$

$$\begin{cases} n\sin (\varphi + \beta) = \sin (\varphi + \beta') \\ n [\tan \varphi \cos \beta + \sin \beta] = \tan \varphi \cos \beta' + \sin \beta' \\ \tan \varphi (n\cos \beta - \cos \beta') = \sin \beta' - n\sin \beta \\ \tan \varphi = -\frac{n\sin \beta - \sin \beta''}{n\cos \beta - \cos \beta'} \end{cases} \qquad (12)$$

By expressing Erg. (12) in terms of anglers $\beta$ and $\gamma$.

$$-\frac{x_p}{\rho} = n\sin(\gamma - \beta)$$

$$\beta - \gamma = \arcsin\left(\frac{x_p}{n\rho}\right)$$

$$\frac{d\beta}{dx_p} = \frac{1}{\sqrt{n^2 \rho^2 - x_p^2}} - \frac{1}{\sqrt{\rho^2 - x_p^2}} \qquad (13)$$

$$\frac{d\tan \beta}{dx_p} = (1 + \tan^2 \beta)\left[\frac{1}{\sqrt{n^2 \rho^2 - x_p^2}} - \frac{1}{\sqrt{\rho^2 - x_p^2}}\right]$$

Angles $\beta$ e $\beta'$ are:

$$\gamma = -\arcsin\left(\frac{x_p}{\rho}\right)$$

$$\beta = \gamma - \arcsin[n^{-1}\sin \gamma] \qquad (14)$$

$$\beta' = \arctan\frac{x_f - x_q}{z_f - z_q}$$

Finally, the interjection of the refracted ray with the rear surface (i.e. slope facet) is given by:

$$z_p - z_q(x_q) = (x_p - x_q)/\tan \beta$$

$$z_q(x_q) + (x_p - x_q)/\tan \beta - z_p = 0 \qquad (15)$$

By using Eq. 15, it is possible to determine the coordinates $(x_q, z_q)$ of each point on the rear surface for each entrance point $(x_p, z_p)$ of a ray corresponding to each point of the lenticular profile located on the front smface. In such way, the profile of the focalisation region of the slope facet is determined.

By repeating the same procedure for all the lenticular elements, the profiles of all the respective corresponding focalisation regions of the slope facets can be determined, so as to determine the whole profile of the lens.

**Claims**

1.  A solar concentrator (40) comprising:

at least one solar cell (42) comprising a front surface, and
an optical system concentrating solar radiation towards the solar cell, the system comprising an optical stepped lens (41; 20; 100; 110) having a front surface (21; 105) for receiving the solar radiation and an opposite rear surface (22; 106) facing the front surface of the solar cell, the rear surface having a stepped profile defining a plurality of stepped structures (46; 24; 102; 116,117), wherein:

each stepped structure, in a cross-sectional plane of the lens, has a saw-tooth shape and is formed by a slope facet (29; 66; 93) and a draft facet (28; 67; 94), the slope and draft facets having different inclinations, each stepped structure being **characterised by** a pitch (P), wherein the slope facet extends for a first length in the cross-sectional plane and the draft facet extends for a second length in the cross-sectional plane;

the front surface of the lens comprises a plurality of contiguous lenticular converging elements (47; 23; 101; 113,118), each lenticular element having a first and a second peripheral edge and a width ($w_L$) extending between the first and the second peripheral edges;

each lenticular element lies opposite to a corresponding stepped structure, the number of the plurality of lenticular elements corresponding to the number of the plurality of stepped structures, and

each lenticular element has an outwardly convex surface in the cross-sectional plane and a width equal to the pitch of the corresponding stepped structure.

2. The concentrator of claim 1, wherein the rear surfaces comprises a central portion, the plurality of stepped structures being arranged outwardly the central portion.

3. The concentrator of anyone of the preceding claims, wherein each stepped structure has a pitch of from 0.1mm to 10 mm.

4. The concentrator of anyone of the preceding claims, wherein each lenticular element has a circular arc profile in the cross-sectional plane with a radius ($R_L$) equal to at least three times the pitch of the corresponding stepped structure.

5. The concentrator of anyone of the preceding claims, wherein the lenticular elements have an aspect ratio of from 0.005 to 0.05.

6. The concentrator of claim 1, wherein minimum thickness of the lens is not smaller than 3 mm and preferably not larger than 5 mm.

7. The concentrator of claim 1 or 6, wherein a maximum depth of a stepped structure is defined as the cross-sectional length difference between the maximum thickness and the minimum thickness of the lens and it is not larger than 1.5 mm, preferably not larger than 1 mm.

8. The concentrator of anyone of the preceding claims, wherein the stepped lens is a Fresnel lens (41; 20; 110) with axial symmetry and the stepped structures have an inplane annular shape.

9. The concentrator of claim 1, wherein at least a first sub-plurality (114) of the plurality of stepped structures use total internal reflection, each stepped structure (92; 116) of the first sub-plurality comprising a reflective slope facet (93) and the draft facet (94) receives a first and second ray (90a,90b) refracted by the front surface of the lens and reflected by the slope facet from respective first and second intercept points (98,99) at respective fifth and sixth intercept points (96,97) of the draft facet, and wherein the draft facet extends for a second length in the cross-sectional plane and the facet portion extending between the fifth and sixth intercept point extends within the second length.

10. The concentrator of claim 9, wherein the plurality of stepped structures (114,115) further comprises:

a second sub-plurality (115) of stepped structures using refraction, wherein each structure (117) of the second plurality comprise a refractive slope facet, and wherein

the first and second incident ray striking the refractive slope facet of a stepped structure (117) of the second sub-plurality at respective first and second intercept point of the slope facet are refracted to exit the lens.

11. A method for designing a stepped lens (41; 20; 100; 110) for a solar concentrator, the stepped lens comprising a front surface for receiving an incident radiation, and an opposite rear surface comprising a stepped profile defining a plurality of stepped structures (46; 24; 102; 116,117), each stepped structure having a saw-tooth shape in a cross-sectional plane of the lens and being formed by a slope facet (29) and a draft facet (28), the slope and draft facets having different inclinations, wherein:

the slope facet extends for a first length in the cross-sectional plane and the draft facet extends for a second length in the cross-sectional plane;
the front surface of the lens comprises a plurality of contiguous lenticular converging elements (47; 23; 101; 113,118), each lenticular element having a first and a second peripheral edge and an outwardly convex surface in the cross-sectional plane, the method comprising:

- selecting a plurality of input parameters of the lens, the input parameters including a minimum thickness of the lens; a refractive index of the lens; a position of the optical focus with respect to the lens; a number of stepped structures; a draft angle and a pitch for each stepped structure; a number of lenticular elements set to be equal to the number of stepped structures; an aspect ratio and a width of each lenticular element corresponding to a respective stepped structure, wherein the width is defined between the first and the second peripheral edge,
- setting the width of each lenticular element to be equal to the pitch of the corresponding stepped structure;
- calculating the profile of a focalisation region of each stepped structure by using the input parameters for each stepped structure and its corresponding lenticular element by

calculating, by applying the Snell's law, an optical path of a first ray (30) perpendicularly incident on a first peripheral edge (34b) of the lenticular element (23b) corresponding to each stepped structure within the lens and emerging from the lens rear surface, wherein the position at which the optical path of the first ray intercepts the rear surface constitutes a first intercept point (32) of the slope facet (29) of the respective stepped structure, which defines in the rear surface a first edge of the focalisation region, and
calculating, by applying the Snell's law, an optical path of a second ray (31) perpendicularly incident on a second peripheral edge (34c) of the lenticular element and emerging from the lens rear surface, wherein the position at which the optical path of the second ray intercepts the rear surface constitutes a second intercept point (33) of the slope facet (29) of the same stepped structure, which defines in the rear surface a second edge of the focalisation region so that the extension of the focalisation region is determined.

12. The method of claim 11, further comprising determining the profile of the focalisation region by calculating the optical path of normal rays incident on the lenticular element at a plurality of incident positions intermediate the first and second peripheral edges.

13. The method of claim 11, wherein, under the condition that the incident radiation converges to a single focal point, calculating the profile of the focalisation region of each stepped structure is by determining the coordinates $(x_q, z_q)$ of each point on the rear surface as intersection of a refracted ray with the rear surface for each entrance point $(x_p, z_p)$ of the ray corresponding to each point of the lenticular profile located on the front surface according to

$$z_p - z_q(x_q) = (x_p - x_q)/\tan\beta$$

$$z_q(x_q) + (x_p - x_q)/\tan\beta - z_p = 0$$

with $\beta$ being the angle of the ray refracted by the lenticular element,
the method further comprising repeating the same procedure for all the lenticular elements so as to determine the profiles of all the respective corresponding focalisation regions of the slope facets and consequently the whole profile of the lens.

**Patentansprüche**

1. Solarkonzentrator (40) umfassend:

zumindest eine Solarzelle (42) umfassend eine Vorderfläche, und
ein optisches System, das die Sonnenstrahlung zu der Solarzelle hin konzentriert, wobei das System eine gestufte optische Linse (41; 20; 100; 110) mit einer Vorderfläche (21; 105) zur Aufnahme der Sonnenstrahlung und einer gegenüberliegenden Rückfläche (22; 106) umfasst, die zur Vorderfläche der Solarzelle weist, wobei die Rückfläche ein gestuftes Profil aufweist, das eine Vielzahl von gestuften Strukturen (46; 24; 102; 116, 117) definiert, wobei:

jede gestufte Struktur in einer Querschnittsebene der Linse eine sägezahnförmige Gestalt aufweist und durch eine Schrägfacette (29; 66; 93) und eine Steilfacette (28; 67; 94) gebildet wird, wobei die Schräg- und Steilfacetten unterschiedliche Neigungen aufweisen, und wobei jede gestufte Struktur durch eine Teilung (P) gekennzeichnet ist, wobei die Schrägfacette sich über eine erste Länge in der Querschnittsebene erstreckt und die Steilfacette sich über eine zweite Länge in der Querschnittsebene erstreckt;

wobei die Vorderfläche der Linse eine Vielzahl von zusammenhängenden, linsenförmigen, konvergierenden Elementen (47; 23; 101; 113, 118) umfasst, wobei jedes linsenförmige Element einen ersten und einen zweiten umlaufenden Rand und eine Breite ($w_L$) aufweist, die sich zwischen den ersten und zweiten umlaufenden Rändern erstreckt;

wobei jedes linsenförmige Element einer entsprechenden gestuften Struktur gegenüberliegt, wobei die Anzahl der Vielzahl von linsenförmigen Elementen der Anzahl der Vielzahl von gestuften Strukturen entspricht, und

wobei jedes linsenförmige Element in der Querschnittsebene eine nach außen konvexe Oberfläche und eine Breite aufweist, die der Teilung der entsprechenden gestuften Struktur entspricht.

2. Konzentrator nach Anspruch 1, wobei die Rückfläche einen zentralen Abschnitt umfasst, wobei die Vielzahl von gestuften Strukturen außerhalb des zentralen Abschnitts angeordnet ist.

3. Konzentrator nach einem der vorhergehenden Ansprüche, wobei jede gestufte Struktur eine Teilung von 0,1 mm bis 10 mm aufweist.

4. Konzentrator nach einem der vorhergehenden Ansprüche, wobei jedes linsenförmige Element in der Querschnittsebene ein Kreisbogenprofil mit einem Radius ($R_L$) gleich zumindest dem Dreifachen der Teilung der entsprechenden Struktur aufweist.

5. Konzentrator nach einem der vorhergehenden Ansprüche, wobei die linsenförmigen Elemente ein Seitenverhältnis von 0,005 bis 0,05 aufweisen.

6. Konzentrator nach Anspruch 1, wobei die minimale Dicke der Linse nicht kleiner als 3 mm und vorzugsweise nicht größer als 5 mm ist.

7. Konzentrator nach Anspruch 1 oder 6, wobei eine maximale Tiefe einer gestuften Struktur als die Querschnittslängendifferenz zwischen der maximalen Dicke und der minimalen Dicke der Linse definiert und nicht größer als 1,5 mm ist, vorzugsweise nicht größer als 1 mm.

8. Konzentrator nach einem der vorhergehenden Ansprüche, wobei die gestufte Linse eine Fresnel-Linse (41; 20; 110) mit axialer Symmetrie ist, und die gestuften Strukturen in der Ebene eine ringförmige Gestalt aufweisen.

9. Konzentrator nach Anspruch 1, wobei zumindest eine erste Teilvielzahl (114) der Vielzahl von gestuften Strukturen interne Totalreflexion verwendet, wobei jede gestufte Struktur (92; 116) der ersten Teilvielzahl eine reflektierende Schrägfacette (93) aufweist, und die Steilfacette (94) einen ersten und zweiten Strahl (90a, 90b) empfängt, die von der Vorderfläche der Linse gebrochen und durch die Schrägfacette von jeweiligen ersten und zweiten Schnittpunkten (98, 99) an jeweiligen fünften und sechsten Schnittpunkten (96, 97) der Steilfacette empfangen werden, und wobei die Steilfacette sich über eine zweite Länge in der Querschnittsebene erstreckt, und der sich zwischen dem fünften und sechsten Schnittpunkt erstreckende Facettenabschnitt sich innerhalb der zweiten Länge erstreckt.

10. Konzentrator nach Anspruch 9, wobei die Vielzahl von gestuften Strukturen (114, 115) des Weiteren umfasst:

eine zweite Teilvielzahl (115) von gestuften Strukturen, die Lichtbrechung verwenden, wobei jede Struktur (117) der zweiten Vielzahl eine lichtbrechende Schrägfacette aufweist, und wobei der erste und zweite einfallende Strahl, die auf die lichtbrechende Schrägfacette einer gestuften Struktur (117) der zweiten Teilvielzahl an jeweiligen ersten und zweiten Schnittpunkten der Schrägfacette treffen, gebrochen werden, um die Linse zu verlassen.

**11.** Verfahren zur Konstruktion einer gestuften Linse (41; 20; 100; 110) für einen Solarkonzentrator, wobei die gestufte Linse eine Vorderfläche zur Aufnahme einer auftreffenden Strahlung sowie eine gegenüberliegende Rückfläche mit einem gestuften Profil umfasst, das eine Vielzahl von gestuften Strukturen (46; 24; 102; 116, 117) umfasst, wobei jede gestufte Struktur in einer Querschnittsebene der Linse eine sägezahnförmige Gestalt aufweist und durch eine Schrägfacette (29) und eine Steilfacette (28) gebildet wird, wobei die Schräg- und Steilfacetten unterschiedliche Neigungen aufweisen, wobei:

die Schrägfacette sich über eine erste Länge in der Querschnittsebene erstreckt und die Steilfacette sich über eine zweite Länge in der Querschnittsebene erstreckt;
wobei die Vorderfläche der Linse eine Vielzahl von zusammenhängenden, linsenförmigen konvergierenden Elementen (47; 23; 101; 113, 118) umfasst, wobei jedes linsenförmige Element einen ersten und einen zweiten umlaufenden Rand und eine nach außen konvexe Oberfläche in der Querschnittsebene aufweist, wobei das Verfahren die folgenden Schritte umfasst:

- Auswählen einer Vielzahl von Eingangsparametern der Linse, wobei die Eingangsparameter eine minimale Dicke der Linse; einen Brechungsindex der Linse; eine Stellung des optischen Brennpunkts relativ zur Linse; eine Anzahl von gestuften Strukturen; einen Steilwinkel und eine Teilung für jede gestufte Struktur; eine Anzahl von linsenförmigen Elementen, die gleich der Anzahl von gestuften Strukturen festgelegt wird; ein Seitenverhältnis und eine Breite jedes linsenförmigen Elements entsprechend einer jeweiligen gestuften Struktur, wobei die Breite zwischen dem ersten und zweiten umlaufenden Rand definiert ist; umfassen;
- Festlegen der Breite jedes linsenförmigen Elements gleich der Teilung der entsprechenden gestuften Struktur;
- Berechnen des Profils eines Fokussierungsbereichs jeder gestuften Struktur unter Verwendung der Eingangsparameter für jede gestufte Struktur und ihr entsprechendes linsenförmiges Element durch

Berechnen, unter Anwendung des Snellius'schen Brechungsgesetzes, eines optischen Pfads eines ersten senkrecht auf einen ersten umlaufenden Rand (34b) des linsenförmigen Elements (23b) einfallenden Strahls (30) entsprechend einer jeden gestuften Struktur innerhalb der Linse und ausgehend von der Linsenrückfläche, wobei die Position, an der der optische Pfad des ersten Strahls die Rückfläche schneidet, einen ersten Schnittpunkt (32) der Schrägfacette (29) der jeweiligen gestuften Struktur bildet, der in der Rückfläche einen ersten Rand des Fokussierungsbereichs definiert, und
Berechnen, unter Anwendung des Snellius'schen Brechungsgesetzes, eines optischen Pfads eines zweiten senkrecht auf einen zweiten umlaufenden Rand (34c) des linsenförmigen Elements einfallenden Strahls (31) ausgehend von der Linsenrückfläche, wobei die Position, an der der optische Pfad des zweiten Strahls die Rückfläche schneidet, einen zweiten Schnittpunkt (33) der Schrägfacette (29) derselben gestuften Struktur bildet, der in der Rückfläche einen zweiten Rand des Fokussierungsbereichs definiert, so dass die Ausdehnung der Fokussierungsregion bestimmt wird.

**12.** Verfahren nach Anspruch 11, des Weiteren umfassend das Bestimmen des Profils der Fokussierungsregion durch Berechnung des optischen Pfades von senkrechten, auf das linsenförmige Element auftreffenden Strahlen an einer Vielzahl von Einfallspositionen zwischen den ersten und zweiten umlaufenden Rändern.

**13.** Verfahren nach Anspruch 11, wobei unter der Bedingung, dass die einfallende Strahlung in einem einzigen Brennpunkt konvergiert, das Berechnen des Profils des Fokussierungsbereichs jeder gestuften Struktur durch das Bestimmen der Koordinaten $(x_q, z_q)$ eines jeden Punkts an der Rückfläche als Schnitt eines gebrochenen Strahls mit der Rückfläche für jeden Eintrittspunkt $(x_p, z_p)$ des Strahls entsprechend jedem Punkt des linsenförmigen Profils an der Vorderfläche gemäß

$$z_p - z_q(x_q) = (x_p - x_q)/\tan\beta$$

$$z_q(x_q) + (x_p - x_q)/\tan\beta - z_p = 0$$

erfolgt, wobei $\beta$ der Winkel des durch das linsenförmige Element gebrochenen Strahls ist,

wobei das Verfahren des Weiteren das Wiederholen derselben Vorgangsweise für alle linsenförmigen Elemente umfasst, um so die Profile aller jeweiligen entsprechenden Fokussierungsbereiche der Steilfacetten und in der Folge das gesamte Profil der Linse zu bestimmen.

**Revendications**

1.  Concentrateur solaire (40) comprenant :

    au moins une cellule solaire (42) comprenant une surface avant, et
    un système optique concentrant un rayonnement solaire vers la cellule solaire, le système comprenant une lentille optique à échelons (41 ; 20 ; 100 ; 110) ayant une surface avant (21 ; 105) permettant de recevoir le rayonnement solaire et une surface arrière opposée (22 ; 106) faisant face à la surface avant de la cellule solaire, la surface arrière ayant un profil à échelons définissant une pluralité de structures en échelons (46 ; 24 ; 102 ; 116 ; 117), où :

    chaque structure en échelons, dans un plan transversal de la lentille, a une forme en dents de scie et est formée par une facette en pente (29 ; 66 ; 93) et une facette de dépouille (28 ; 67 ; 94), les facettes en pente et de dépouille ayant des inclinaisons différentes, chaque structure en échelons étant **caractérisée par** un pas (P), où la facette en pente s'étend sur une première longueur dans le plan transversal et la facette de dépouille s'étend sur une deuxième longueur dans le plan transversal ;
    la surface avant de la lentille comprend une pluralité d'éléments lenticulaires convergents contigus (47 ; 23 ; 101 ; 113 ; 118), chaque élément lenticulaire ayant des premier et deuxième bords périphériques et une largeur ($W_L$) s'étendant entre les premier et deuxième bords périphériques ;
    chaque élément lenticulaire se situe à l'opposé d'une structure en échelons correspondante, le nombre de la pluralité d'éléments lenticulaires correspondant au nombre de la pluralité de structures en échelons, et chaque élément lenticulaire présente une surface convexe vers l'extérieur dans le plan transversal et une largeur égale au pas de la structure en échelons correspondante.

2.  Concentrateur de la revendication 1, dans lequel la surface arrière comprend une partie centrale, la pluralité de structures en échelons étant agencées extérieurement à la partie centrale.

3.  Concentrateur de l'une quelconque des revendications précédentes, dans lequel chaque structure en échelons a un pas allant de 0,1 mm à 10 mm.

4.  Concentrateur de l'une quelconque des revendications précédentes, dans lequel chaque élément lenticulaire présente un profil en arc de cercle dans le plan transversal avec un rayon ($R_L$) égal à au moins trois fois le pas de la structure en échelons correspondante.

5.  Concentrateur de l'une quelconque des revendications précédentes, dans lequel les éléments lenticulaires ont un rapport d'aspect allant de 0,005 à 0,05.

6.  Concentrateur de la revendication 1, dans lequel une épaisseur minimale de la lentille est supérieure ou égale à 3 mm et de préférence inférieure ou égale à 5 mm.

7.  Concentrateur de la revendication 1 ou 6, dans lequel une profondeur maximale d'une structure en échelons est définie comme étant la différence de longueur en coupe transversale entre l'épaisseur maximale et l'épaisseur minimale de la lentille et elle est inférieure ou égale à 1,5 mm, de préférence inférieure ou égale à 1 mm.

8.  Concentrateur de l'une quelconque des revendications précédentes, dans lequel la lentille à échelons est une lentille de Fresnel (41 ; 20 ; 110) à symétrie axiale et les structures en échelons ont une forme annulaire dans le plan.

9.  Concentrateur de la revendication 1, dans lequel au moins une première sous-pluralité (114) de la pluralité de structures en échelons utilise une réflexion interne totale, chaque structure en échelons (92 ; 116) de la première sous-pluralité comprenant une facette en pente réfléchissante (93) et la facette de dépouille (94) reçoit des premier et deuxième rayons (90a, 90b) réfractés par la surface avant de la lentille et réfléchis par la facette en pente à partir de premier et deuxième points d'interception respectifs (98, 99) à des cinquième et sixième points d'interception respectifs (96, 97) de la facette de dépouille, et où la facette de dépouille s'étend sur une deuxième longueur dans le plan transversal et la partie de facette s'étendant entre les cinquième et sixième points d'interception s'étend sur la deuxième longueur.

10. Concentrateur de la revendication 9, dans lequel la pluralité de structures en échelons (114, 115) comprend en outre :

une deuxième sous-pluralité (115) de structures en échelons en utilisant une réfraction, où chaque structure (117) de la deuxième pluralité comprend une facette en pente réfléchissante, et où les premier et deuxième rayons incidents frappant la facette en pente réfléchissante d'une structure en échelons (117) de la deuxième sous-pluralité à des premier et deuxième points d'interception de la facette en pente sont réfractés pour sortir de la lentille.

11. Procédé de conception d'une lentille à échelons (41 ; 20 ; 100 ; 110) pour un concentrateur solaire, la lentille à échelons comprenant une surface avant permettant de recevoir un rayonnement incident, et une surface arrière opposée comprenant un profil à échelons définissant une pluralité de structures en échelons (46 ; 24 ; 102 ; 116 ; 117), chaque structure en échelons ayant une forme en dents de scie dans un plan transversal de la lentille et étant formée par une facette en pente (29) et une facette de dépouille (28), les facettes en pente et de dépouille ayant des inclinaisons différentes, où :

la facette en pente s'étend sur une première longueur dans le plan transversal et la facette de dépouille s'étend sur une deuxième longueur dans le plan transversal ;
la surface avant de la lentille comprend une pluralité d'éléments lenticulaires convergents contigus (47 ; 23 ; 101 ; 113 ; 118), chaque élément lenticulaire ayant des premier et deuxième bords périphériques et une surface convexe vers l'extérieur dans le plan transversal, le procédé comprenant le fait :

- de sélectionner une pluralité de paramètres d'entrée de la lentille, les paramètres d'entrée comportant une épaisseur minimale de la lentille ; un indice de réfraction de la lentille ; une position du foyer optique par rapport à la lentille ; un certain nombre de structures en échelons ; un angle de dépouille et un pas pour chaque structure en échelons ; un certain nombre d'éléments lenticulaires réglé comme étant égal au nombre de structures en échelons ; un rapport d'aspect et une largeur de chaque élément lenticulaire correspondant à une structure en échelons respective, où la largeur est définie entre les premier et deuxième bords périphériques,
- de régler la largeur de chaque élément lenticulaire comme étant égale au pas de la structure en échelons correspondante ;
- de calculer le profil d'une région de focalisation de chaque structure en échelons en utilisant les paramètres d'entrée pour chaque structure en échelons et son élément lenticulaire correspondant par

le calcul, en appliquant la loi de Snell, d'un chemin optique d'un premier rayon (30) incident perpendiculairement sur un premier bord périphérique (34b) de l'élément lenticulaire (23b) correspondant à chaque structure en échelons dans la lentille et émergeant de la surface arrière de lentille, où la position à laquelle le chemin optique du premier rayon intercepte la surface arrière constitue un premier point d'interception (32) de la facette en pente (29) de la structure en échelons respective, qui définit dans la surface arrière un premier bord de la région de focalisation, et
le calcul, en appliquant la loi de Snell, d'un chemin optique d'un deuxième rayon (31) incident perpendiculairement sur un deuxième bord périphérique (34c) de l'élément lenticulaire et émergeant de la surface arrière de lentille, où la position à laquelle le chemin optique du deuxième rayon intercepte la surface arrière constitue un deuxième point d'interception (33) de la facette en pente (29) de la même structure en échelons, qui définit dans la surface arrière un deuxième bord de la région de focalisation de sorte que l'extension de la région de focalisation soit déterminée.

12. Procédé de la revendication 11, comprenant en outre le fait de déterminer le profil de la région de focalisation en calculant le chemin optique des rayons normaux incidents sur l'élément lenticulaire à une pluralité de positions incidentes entre les premier et deuxième bords périphériques.

13. Procédé de la revendication 11, dans lequel, à condition que le rayonnement incident converge vers un seul point focal, le calcul du profil de la région de focalisation de chaque structure en échelons est effectué en déterminant les coordonnées $(x_q, z_q)$ de chaque point sur la surface arrière en tant qu'intersection d'un rayon réfracté avec la surface arrière pour chaque point d'entrée $(x_p, z_p)$ du rayon correspondant à chaque point du profil lenticulaire situé sur la surface avant selon les équations suivantes :

$$z_p - z_q(x_q) = (x_p - x_q)/\tan\beta$$

$$z_q(x_q) + (x_p - x_q)/\tan\beta - z_p = 0$$

$\beta$ étant l'angle du rayon réfracté par l'élément lenticulaire,
le procédé comprenant en outre le fait de répéter la même procédure pour tous les éléments lenticulaires de manière à déterminer les profils de toutes les régions de focalisation correspondantes respectives des facettes en pente et par conséquent le profil entier de la lentille.

FIG.1

FIG.2

FIG.4

FIG. 3

FIG. 5

FIG. 6

FIG. 8

FIG. 7

FIG. 9a

FIG. 9b

FIG. 10

FIG. 11

FIG. 12

FIG.13

FIG. 14

FIG.15

FIG.16

FIG. 17

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20050092360 A
- US 20030075212 A
- US 4337759 A
- US 20080092879 A
- US 4867514 A
- US 3883733 A
- EP 0117254 A

**Non-patent literature cited in the description**

- **C. PRIVATO et al.** Plastics Structured Optics for Solar Concentrators in PV System. *the proceedings of the International Solar Concentration Conference for the Generation of Electricity and Hydrogen (TCSC-3),* 01 May 2005